# EUROPEAN PATENT APPLICATION

(11) **EP 4 711 775 A1**
(43) Date of publication of application: **18.03.2026**
(21) Application number: 25199572.6
(22) Date of filing: 02.09.2025
(51) Int. Cl.: G01R 21/01

(54) **RADIO-FREQUENCY POWER DETECTOR WITH OFFSET AND TEMPERATURE COMPENSATION**

(30) Priority: 11.09.2024 US 202418830865; 11.09.2024 US 202418830891
(71) Applicant: Apple Inc., Cupertino, CA 95014 (US)
(72) Inventor: WANG, Le, Campbell (US)
(74) Representative: COPA Copenhagen Patents

(57) **Abstract**

Wireless circuitry may include a transmission line that carries a signal and a power detector that measures the signal. The detector may include a rectifier coupled to a comparator over a differential path. An offset calibrating digital-to-analog converter (OSDAC), a reference generator, and a multiplexer may be disposed on a negative line of the differential path. The OSDAC may produce an offset-compensated voltage by adding different offset voltages to a voltage on the second line over time. The reference generator may generate a set of threshold voltages by adding different reference voltages to the offset-compensated voltage. A temperature sensor may adjust the reference voltages used to generate the threshold voltages based on a temperature of the power detector. The multiplexer may route different threshold voltages to a negative input of the comparator.

## Description

This application claims priority to U.S. Patent Application No. 18/830,865, filed September 11, 2024, and U.S. Provisional Patent Application No. 18/830,891, filed September 11, 2024, which are hereby incorporated by reference herein in their entireties.

### Field

This disclosure relates generally to electronic devices, including electronic devices with wireless communications circuitry.

### Background

Electronic devices can be provided with wireless communications capabilities. An electronic device with wireless communications capabilities has wireless communications circuitry with one or more antennas. Wireless transceiver circuitry in the wireless communications circuitry uses the antennas to transmit and receive radio-frequency signals.

Radio-frequency signals transmitted by an antenna can be fed through a power amplifier, which is configured to amplify low power analog signals to higher power signals more suitable for transmission through the air over long distances. Radio-frequency signals received at an antenna can be fed through a low noise amplifier, which is configured to amplify low power analog signals to higher power signals for ease of processing at a receiver. Power detectors can be used to measure the power level of a power amplifier or a low noise amplifier. It can be challenging to design a satisfactory power detector.

### Summary

An electronic device may include wireless circuitry. The wireless circuitry may include a radio-frequency transmission line that carries a radio-frequency signal. The wireless circuitry may include a power detector that measures a power level of the radio-frequency signal.

The power detector may include a rectifier coupled to a comparator over a differential signal path. The differential signal path may include a first line coupled to a positive input of the comparator and may include a second line coupled to a negative input of the comparator. An offset calibrating digital-to-analog converter (OSDAC), a reference generator, and a multiplexer may be disposed on the second line. Digital logic may be operably coupled to an output of the comparator and the multiplexer.

The OSDAC may be calibrated and controlled to produce an offset-compensated voltage by adding different offset voltages to a voltage on the second line over time. The offset voltage may cancel out an offset imparted by the rectifier given its present operating conditions. The reference generator may be calibrated and controlled to generate a set of threshold voltages by adding different reference voltages to the offset-compensated voltage. A temperature sensor may adjust the reference voltages used to generate the threshold voltages based on a temperature of the power detector. The temperature sensor may, for example, adjust adjustable current sources in the reference generator based on the temperature. The multiplexer may route different threshold voltages to the negative input of the comparator. A low pass filter may filter common mode noise from a voltage provided to the positive input of the comparator. The comparator may provide an output signal to the digital logic. The digital logic may control the multiplexer based on the output signal. The digital logic may output a digital code based on the output signal and indicative of the power level of the radio-frequency signal.

### Brief Description of the Drawings

FIG. 1 is a diagram of an illustrative electronic device having wireless circuitry in accordance with some embodiments.
FIG. 2 is a diagram of illustrative wireless circuitry having radio-frequency amplifiers in accordance with some embodiments.
FIG. 3 is a diagram showing illustrative power detectors coupled to radio-frequency amplifier outputs in accordance with some embodiments.
FIG. 4 is a diagram of an illustrative power detector having offset and temperature compensation capabilities in accordance with some embodiments.
FIG. 5 is a circuit diagram of illustrative circuitry in a power detector having offset and temperature compensation capabilities in accordance with some embodiments.
FIG. 6 is a flow chart of illustrative operations involved in operating a power detector in accordance with some embodiments.
FIG. 7 is a timing diagram showing one example of how an illustrative power detector may perform an offset calibration operation in accordance with some embodiments.
FIG. 8 is a timing diagram showing one example of how an illustrative power detector may perform a threshold calibration operation in accordance with some embodiments.
FIG. 9 is a timing diagram showing one example of how an illustrative power detector may measure a radio-frequency signal in accordance with some embodiments.

### Detailed Description

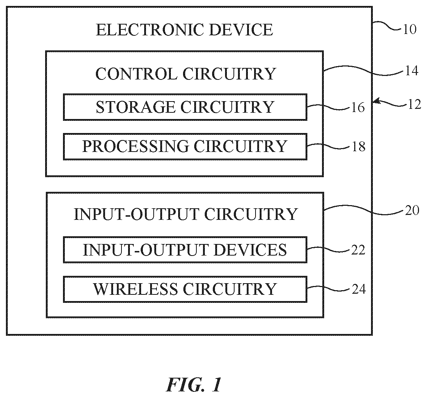

An electronic device such as device 10 of FIG. 1 may be provided with wireless circuitry. Wireless circuitry can include radio-frequency amplifiers such as power amplifiers and low noise amplifiers. Power amplifiers can be used to amplify radio-frequency signals in a transmit path, whereas low noise amplifiers can be used to amplify radio-frequency signals in a receive path. Power detection circuits, sometimes referred to as power detectors, can be coupled at the outputs of these radio-frequency amplifiers. A power detector coupled at the output of a radio-frequency power amplifier can be configured to run an adaptive power control algorithm for adjusting a power level of the power amplifier, whereas a power detector coupled at the output of a radio-frequency low noise amplifier can be used to run an automatic gain control algorithm for adjusting a power level of the low noise amplifier.

Electronic device 10 of FIG. 1 may be a computing device such as a laptop computer, a desktop computer, a computer monitor containing an embedded computer, a tablet computer, a cellular telephone, a media player, or other handheld or portable electronic device, a smaller device such as a wristwatch device, a pendant device, a headphone or earpiece device, a device embedded in eyeglasses, goggles, a helmet, or other equipment worn on a user's head (e.g., an augmented, virtual, or mixed reality head-mounted display device), or another wearable or miniature device, a television, a computer display that does not contain an embedded computer, a gaming device, a navigation device, an embedded system such as a system in which electronic equipment with a display is mounted in a kiosk or automobile, a wireless internet-connected voice-controlled speaker, a home entertainment device, a remote control device, a gaming controller, a peripheral user input device, a wireless base station or access point, equipment that implements the functionality of two or more of these devices, or other electronic equipment.

As shown in the functional block diagram of FIG. 1, device 10 may include components located on or within an electronic device housing such as housing 12. Housing 12, which may sometimes be referred to as a case, may be formed from plastic, glass, ceramics, fiber composites, metal (e.g., stainless steel, aluminum, metal alloys, etc.), other suitable materials, or a combination of these materials. In some embodiments, parts or all of housing 12 may be formed from dielectric or other low-conductivity material (e.g., glass, ceramic, plastic, sapphire, etc.). In other embodiments, housing 12 or at least some of the structures that make up housing 12 may be formed from metal elements.

Device 10 may include control circuitry 14. Control circuitry 14 may include storage such as storage circuitry 16. Storage circuitry 16 may include hard disk drive storage, nonvolatile memory (e.g., flash memory or other electrically-programmable-read-only memory configured to form a solid-state drive), volatile memory (e.g., static or dynamic random-access-memory), etc. Storage circuitry 16 may include storage that is integrated within device 10 and/or removable storage media.

Control circuitry 14 may include processing circuitry such as processing circuitry 18. Processing circuitry 18 may be used to control the operation of device 10. Processing circuitry 18 may include one or more processors such as microprocessors, microcontrollers, digital signal processors, host processors, baseband processor integrated circuits, application specific integrated circuits, central processing units (CPUs), graphics processing units (GPUs), etc. Control circuitry 14 may be configured to perform operations in device 10 using hardware (e.g., dedicated hardware or circuitry), firmware, and/or software. Software code for performing operations in device 10 may be stored on storage circuitry 16 (e.g., storage circuitry 16 may include non-transitory (tangible) computer readable storage media that stores the software code). The software code may sometimes be referred to as program instructions, software, data, instructions, or code. Software code stored on storage circuitry 16 may be executed by processing circuitry 18.

Control circuitry 14 may be used to run software on device 10 such as satellite navigation applications, internet browsing applications, voice-over-internet-protocol (VOIP) telephone call applications, email applications, media playback applications, operating system functions, etc. To support interactions with external equipment, control circuitry 14 may be used in implementing communications protocols. Communications protocols that may be implemented using control circuitry 14 include internet protocols, wireless local area network (WLAN) protocols (e.g., IEEE 802.11 protocols - sometimes referred to as Wi-Fi^{®}), protocols for other short-range wireless communications links such as the Bluetooth^{®} protocol or other wireless personal area network (WPAN) protocols, IEEE 802.11ad protocols (e.g., ultra-wideband protocols), cellular telephone protocols (e.g., 3G protocols, 4G (LTE) protocols, 3GPP Fifth Generation (5G) New Radio (NR) protocols, Sixth Generation (6G) protocols, sub-THz protocols, THz protocols, etc.), antenna diversity protocols, satellite navigation system protocols (e.g., global positioning system (GPS) protocols, global navigation satellite system (GLONASS) protocols, etc.), antenna-based spatial ranging protocols, optical communications protocols, or any other desired communications protocols. Each communications protocol may be associated with a corresponding radio access technology (RAT) that specifies the physical connection methodology used in implementing the protocol.

Device 10 may include input-output circuitry 20. Input-output circuitry 20 may include input-output devices 22. Input-output devices 22 may be used to allow data to be supplied to device 10 and to allow data to be provided from device 10 to external devices. Input-output devices 22 may include user interface devices, data port devices, and other input-output components. For example, input-output devices 22 may include touch sensors, displays (e.g., touch-sensitive and/or force-sensitive displays), light-emitting components such as displays without touch sensor capabilities, buttons (mechanical, capacitive, optical, etc.), scrolling wheels, touch pads, key pads, keyboards, microphones, cameras, buttons, speakers, status indicators, audio jacks and other audio port components, digital data port devices, motion sensors (accelerometers, gyroscopes, and/or compasses that detect motion), capacitance sensors, proximity sensors, magnetic sensors, force sensors (e.g., force sensors coupled to a display to detect pressure applied to the display), etc. In some configurations, keyboards, headphones, displays, pointing devices such as trackpads, mice, and joysticks, and other input-output devices may be coupled to device 10 using wired or wireless connections (e.g., some of input-output devices 22 may be peripherals that are coupled to a main processing unit or other portion of device 10 via a wired or wireless link).

Input-output circuitry 20 may include wireless circuitry 24 to support wireless communications. Wireless circuitry 24 (sometimes referred to herein as wireless communications circuitry 24) may include one or more antennas. Wireless circuitry 24 may also include baseband processor circuitry, transceiver circuitry, amplifier circuitry, filter circuitry, switching circuitry, radio-frequency transmission lines, and/or any other circuitry for transmitting and/or receiving radio-frequency signals using the antenna(s).

Wireless circuitry 24 may transmit and/or receive radio-frequency signals within a corresponding frequency band at radio frequencies (sometimes referred to herein as a communications band or simply as a "band"). The frequency bands handled by wireless circuitry 24 may include wireless local area network (WLAN) frequency bands (e.g., Wi-Fi^{®} (IEEE 802.11) or other WLAN communications bands) such as a 2.4 GHz WLAN band (e.g., from 2400 to 2480 MHz), a 5 GHz WLAN band (e.g., from 5180 to 5825 MHz), a Wi-Fi^{®} 6E band (e.g., from 5925-7125 MHz), a Wi-Fi^{®} 7 band, and/or other Wi-Fi^{®} bands (e.g., from 1875-5160 MHz), wireless personal area network (WPAN) frequency bands such as the 2.4 GHz Bluetooth^{®} band or other WPAN communications bands, cellular telephone frequency bands (e.g., bands from about 600 MHz to about 5 GHz, 3G bands, 4G LTE bands, 5G New Radio Frequency Range 1 (FR1) bands below 10 GHz, 5G New Radio Frequency Range 2 (FR2) bands between 20 and 60 GHz, etc.), other centimeter or millimeter wave frequency bands between 10-100 GHz, sub-THz frequency bands between around 100 GHz and 10 THz (e.g., 6G bands), near-field communications (NFC) frequency bands (e.g., at 13.56 MHz), satellite navigation frequency bands (e.g., a GPS band from 1565 to 1610 MHz, a Global Navigation Satellite System (GLONASS) band, a BeiDou Navigation Satellite System (BDS) band, etc.), ultra-wideband (UWB) frequency bands that operate under the IEEE 802.15.4 protocol and/or other ultra-wideband communications protocols, communications bands under the family of 3GPP wireless communications standards, communications bands under the IEEE 802.XX family of standards, and/or any other desired frequency bands of interest.

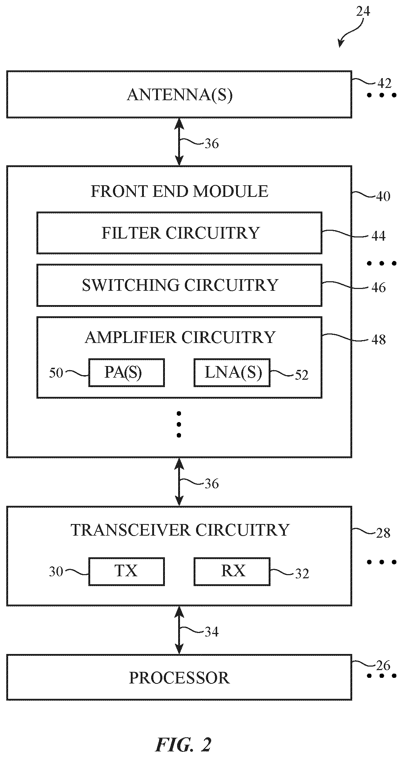

FIG. 2 is a diagram showing illustrative components within wireless circuitry 24. As shown in FIG. 2, wireless circuitry 24 may include a processor such as processor 26, radio-frequency (RF) transceiver circuitry such as radio-frequency transceiver 28, radio-frequency front end circuitry such as radio-frequency front end module (FEM) 40, and antenna(s) 42. Processor 26 may be a baseband processor, application processor, general purpose processor, microprocessor, microcontroller, digital signal processor, host processor, application specific signal processing hardware, or other type of processor. Processor 26 may be coupled to transceiver 28 over path 34. Transceiver 28 may be coupled to antenna 42 via radio-frequency transmission line path 36. Radio-frequency front end module 40 may be disposed on radio-frequency transmission line path 36 between transceiver 28 and antenna 42.

In the example of FIG. 2, wireless circuitry 24 is illustrated as including only a single processor 26, a single transceiver 28, a single front end module 40, and a single antenna 42 for the sake of clarity. In general, wireless circuitry 24 may include any desired number of processors 26, any desired number of transceivers 28, any desired number of front end modules 40, and any desired number of antennas 42. Each processor 26 may be coupled to one or more transceiver 28 over respective paths 34. Each transceiver 28 may include a transmitter circuit 30 configured to output uplink signals to antenna 42, may include a receiver circuit 32 configured to receive downlink signals from antenna 42, and may be coupled to one or more antennas 42 over respective radio-frequency transmission line paths 36. Each radio-frequency transmission line path 36 may have a respective front end module 40 disposed thereon. If desired, two or more front end modules 40 may be disposed on the same radio-frequency transmission line path 36. If desired, one or more of the radio-frequency transmission line paths 36 in wireless circuitry 24 may be implemented without any front end module disposed thereon.

Radio-frequency transmission line path 36 may be coupled to an antenna feed on antenna 42. The antenna feed may, for example, include a positive antenna feed terminal and a ground antenna feed terminal. Radio-frequency transmission line path 36 may have a positive transmission line signal path such that is coupled to the positive antenna feed terminal on antenna 42. Radio-frequency transmission line path 36 may have a ground transmission line signal path that is coupled to the ground antenna feed terminal on antenna 42. This example is merely illustrative and, in general, antennas 42 may be fed using any desired antenna feeding scheme. If desired, antenna 42 may have multiple antenna feeds that are coupled to one or more radio-frequency transmission line paths 36.

Radio-frequency transmission line path 36 may include transmission lines that are used to route radio-frequency antenna signals within device 10 (FIG. 1). Transmission lines in device 10 may include coaxial cables, microstrip transmission lines, stripline transmission lines, edge-coupled microstrip transmission lines, edge-coupled stripline transmission lines, transmission lines formed from combinations of transmission lines of these types, etc. Transmission lines in device 10 such as transmission lines in radio-frequency transmission line path 36 may be integrated into rigid and/or flexible printed circuit boards.

In performing wireless transmission, processor 26 may provide transmit signals (e.g., digital or baseband signals) to transceiver 28 over path 34. Transceiver 28 may further include circuitry for converting the transmit (baseband) signals received from processor 26. For example, transceiver circuitry 28 may include mixer circuitry for up-converting (or modulating) the transmit (baseband) signals to radio frequencies prior to transmission over antenna 42. The example of FIG. 2 in which processor 26 communicates with transceiver 28 is merely illustrative. In general, transceiver 28 may communicate with a baseband processor, an application processor, general purpose processor, a microcontroller, a microprocessor, or one or more processors within circuitry 18. Transceiver circuitry 28 may also include digital-to-analog converter (DAC) and/or analog-to-digital converter (ADC) circuitry for converting signals between digital and analog domains. Transceiver 28 may use transmitter (TX) 30 to transmit the radio-frequency signals over antenna 42 via radio-frequency transmission line path 36 and front end module 40. Antenna 42 may transmit the radio-frequency signals to external wireless equipment by radiating the radio-frequency signals into free space.

In performing wireless reception, antenna 42 may receive radio-frequency signals from the external wireless equipment. The received radio-frequency signals may be conveyed to transceiver 28 via radio-frequency transmission line path 36 and front end module 40. Transceiver 28 may include circuitry such as receiver (RX) 32 for receiving signals from front end module 40 and for converting the received radio-frequency signals into corresponding baseband signals. For example, transceiver 28 may include mixer circuitry for down-converting (or demodulating) the received radio-frequency signals to baseband frequencies prior to conveying the received signals to processor 26 over path 34.

Front end module (FEM) 40 may include radio-frequency front end circuitry that operates on the radio-frequency signals conveyed (transmitted and/or received) over radio-frequency transmission line path 36. FEM 40 may, for example, include front end module (FEM) components such as radio-frequency filter circuitry 44 (e.g., low pass filters, high pass filters, notch filters, band pass filters, multiplexing circuitry, duplexer circuitry, diplexer circuitry, triplexer circuitry, etc.), switching circuitry 46 (e.g., one or more radio-frequency switches), radio-frequency amplifier circuitry 48 (e.g., one or more power amplifier circuits 50 and/or one or more low-noise amplifier circuits 52), signal attenuators, impedance matching circuitry (e.g., circuitry that helps to match the impedance of antenna 42 to the impedance of radio-frequency transmission line 36), antenna tuning circuitry (e.g., networks of capacitors, resistors, inductors, and/or switches that adjust the frequency response of antenna 42), radio-frequency coupler circuitry, charge pump circuitry, power management circuitry, digital control and interface circuitry, and/or any other desired circuitry that operates on the radio-frequency signals transmitted and/or received by antenna 42. Each of the front end module components may be mounted to a common (shared) substrate such as a rigid printed circuit board substrate or flexible printed circuit substrate. If desired, the various front end module components may also be integrated into a single integrated circuit chip. If desired, amplifier circuitry 48 and/or other components in front end 40 such as filter circuitry 44 may also be implemented as part of transceiver circuitry 28.

Filter circuitry 44, switching circuitry 46, amplifier circuitry 48, and other circuitry may be disposed along radio-frequency transmission line path 36, may be incorporated into FEM 40, and/or may be incorporated into antenna 42 (e.g., to support antenna tuning, to support operation in desired frequency bands, etc.). These components, sometimes referred to herein as antenna tuning components, may be adjusted (e.g., using control circuitry 14) to adjust the frequency response and wireless performance of antenna 42 over time.

Transceiver 28 may be separate from front end module 40. For example, transceiver 28 may be formed on another substrate such as the main logic board of device 10, a rigid printed circuit board, or flexible printed circuit that is not a part of front end module 40. While control circuitry 14 is shown separately from wireless circuitry 24 in the example of FIG. 1 for the sake of clarity, wireless circuitry 24 may include processing circuitry that forms a part of processing circuitry 18 and/or storage circuitry that forms a part of storage circuitry 16 of control circuitry 14 (e.g., portions of control circuitry 14 may be implemented on wireless circuitry 24). As an example, processor 26 and/or portions of transceiver 28 (e.g., a host processor on transceiver 28) may form a part of control circuitry 14. Control circuitry 14 (e.g., portions of control circuitry 14 formed on processor 26, portions of control circuitry 14 formed on transceiver 28, and/or portions of control circuitry 14 that are separate from wireless circuitry 24) may provide control signals (e.g., over one or more control paths in device 10) that control the operation of front end module 40.

Transceiver 28 may include wireless local area network transceiver circuitry that handles WLAN communications bands (e.g., Wi-Fi^{®} (IEEE 802.11) or other WLAN communications bands) such as a 2.4 GHz WLAN band (e.g., from 2400 to 2480 MHz), a 5 GHz WLAN band (e.g., from 5180 to 5825 MHz), a Wi-Fi^{®} 6E band (e.g., from 5925-7125 MHz), and/or other Wi-Fi^{®} bands (e.g., from 1875-5160 MHz), wireless personal area network transceiver circuitry that handles the 2.4 GHz Bluetooth^{®} band or other WPAN communications bands, cellular telephone transceiver circuitry that handles cellular telephone bands (e.g., bands from about 600 MHz to about 5 GHz, 3G bands, 4G LTE bands, 5G New Radio Frequency Range 1 (FR1) bands below 10 GHz, 5G New Radio Frequency Range 2 (FR2) bands between 20 and 60 GHz, 6G bands above 100 GHz, etc.), near-field communications (NFC) transceiver circuitry that handles near-field communications bands (e.g., at 13.56 MHz), satellite navigation receiver circuitry that handles satellite navigation bands (e.g., a GPS band from 1565 to 1610 MHz, a Global Navigation Satellite System (GLONASS) band, a BeiDou Navigation Satellite System (BDS) band, etc.), ultra-wideband (UWB) transceiver circuitry that handles communications using the IEEE 802.15.4 protocol and/or other ultra-wideband communications protocols, and/or any other desired radio-frequency transceiver circuitry for covering any other desired communications bands of interest.

Wireless circuitry 24 may include one or more antennas such as antenna 42. Antenna 42 may be formed using any desired antenna structures. For example, antenna 42 may be an antenna with a resonating element that is formed from loop antenna structures, patch antenna structures, inverted-F antenna structures, slot antenna structures, planar inverted-F antenna structures, helical antenna structures, monopole antennas, dipoles, hybrids of these designs, etc. Two or more antennas 42 may be arranged into one or more phased antenna arrays (e.g., for conveying radio-frequency signals at millimeter wave frequencies). Parasitic elements may be included in antenna 42 to adjust antenna performance. Antenna 42 may be provided with a conductive cavity that backs the antenna resonating element of antenna 42 (e.g., antenna 42 may be a cavity-backed antenna such as a cavity-backed slot antenna).

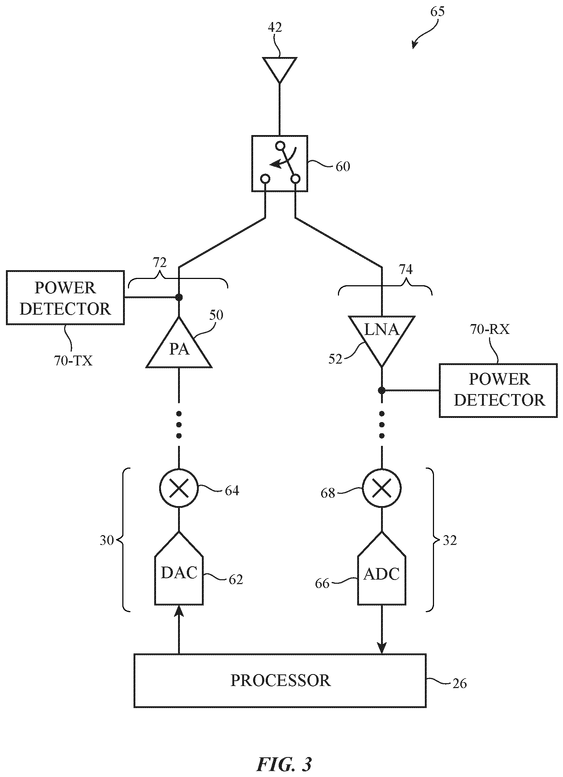

Radio-frequency amplifiers may be coupled to power detectors for power level monitoring purposes. FIG. 3 is a diagram showing illustrative power detectors coupled to radio-frequency amplifier outputs. As shown in FIG. 3, wireless circuitry 24 can have one or more antenna 42 that is coupled to a transmit path 72 and a receive path 74 via a radio-frequency duplexing circuit such as duplexer 60. Duplexer 60 may have a first port coupled to a shared antenna 42, a second port coupled to transmit path 72 (e.g., a second port configured to receive amplified radio-frequency signals to be radiated by antenna 42), and a third port coupled to receive path 74 (e.g., a third port to which radio-frequency signals received by antenna 42 are conveyed).

Receive path 74 (sometimes also referred to herein as receive chain 74) can include low noise amplifier (LNA) circuitry 52, a downconverting mixing circuit such as mixer 68, and a data converter such as analog-to-digital converter (ADC) 66. The LNA circuitry 52 can include one or more amplifiers coupled in series and/or in parallel. Mixer 68 may use a local oscillator signal to downconvert (or demodulate) the radio-frequency signals to baseband (or intermediate) frequencies. Analog-to-digital converter (ADC) circuit 66 can then convert the demodulated signals from the analog domain to the digital domain to generate corresponding digital baseband signals. Mixer 68 and ADC circuit 66 are sometimes be considered part of receiver circuitry 32. The digital baseband signals can then be received by one or more processors 26. Processor 26 may represent one or more processors such as a baseband processor, an application processor, a digital signal processor, a microcontroller, a microprocessor, a central processing unit (CPU), a programmable device, a combination of these circuits, and/or one or more processors within circuitry 18 (see FIG. 1).

The circuitry described above for processing signals received by antenna 42 is sometimes referred to collectively as wireless *receiving* circuitry. If desired, one or more additional front end module components such as radio-frequency filter circuitry 44 of FIG. 2 (e.g., low pass filters, high pass filters, notch filters, band pass filters, attenuators, multiplexing circuitry, duplexer circuitry, diplexer circuitry, triplexer circuitry, etc.), switching circuitry 46 (e.g., one or more radio-frequency switches), impedance matching circuitry, antenna tuning circuitry (e.g., networks of capacitors, resistors, inductors, and/or switches that adjust the frequency response of antenna 42), radio-frequency coupler circuitry, charge pump circuitry, power management circuitry, and/or any other desired front-end module circuitry can optionally be coupled at the input and/or output of LNA circuitry 52 along the radio-frequency reception line path.

On the other hand, transmit path 74 (sometimes also referred to herein as transmit chain 74) can include power amplifier (PA) circuitry 50, an upconverting mixing circuit such as mixer 64, and a data converter such as digital-to-analog converter (DAC) 62. Processor 26 can generate digital baseband signals, sometimes referred to as digital signals for transmission. DAC circuit 62 can convert the digital baseband signals from the digital domain to the analog domain to generate corresponding analog baseband signals. Mixer 64 may use a local oscillator signal to upconvert (or modulate) the radio-frequency signals to radio (or intermediate) frequencies. DAC circuit 62 and mixer 64 are sometimes be considered part of transmitter circuitry 30. The upconverted radio-frequency signals can then be fed to amplifier circuitry 50. The PA circuitry 52 can include one or more amplifiers coupled in series and/or in parallel that are configured to amplify signals for transmission by antenna 42.

The circuitry described above for preparing signals for transmission by antenna 42 is sometimes referred to collectively as wireless *transmitting* circuitry. If desired, one or more additional front end module components such as radio-frequency filter circuitry 44 of FIG. 2 (e.g., low pass filters, high pass filters, notch filters, band pass filters, attenuators, multiplexing circuitry, duplexer circuitry, diplexer circuitry, triplexer circuitry, etc.), switching circuitry 46 (e.g., one or more radio-frequency switches), impedance matching circuitry, antenna tuning circuitry (e.g., networks of capacitors, resistors, inductors, and/or switches that adjust the frequency response of antenna 42), radio-frequency coupler circuitry, charge pump circuitry, power management circuitry, and/or any other desired front-end module circuitry can optionally be coupled at the input and/or output of amplifier circuitry 50 along the radio-frequency transmission line path.

Power (transmitting) amplifiers 50 and low noise (receiving) amplifiers 52 can be referred to collectively as radio-frequency amplifiers. Power detection circuits can be coupled to the outputs of the radio-frequency amplifiers to enable power monitoring operations. Still referring to FIG. 3, a first power detection circuit such as power detector 70-TX may be coupled to the output of transmitting amplifier circuitry 50, whereas a second power detection circuit such as power detector 70-RX may be coupled to the output of receiving amplifier circuitry 52. Power detector 70-TX can be used to detect or measure an output power level of radio-frequency signals generated at the output of amplifier circuitry 50. The detected output power level can then be used by an automatic power control (APC) algorithm to dynamically adjust the gain of power amplifier circuitry 50 to ensure that the transmit path is outputting signals at desired power levels. The APC algorithm, which can run on processor 26 or other control circuitry in device 10, can compare the measured output power level to a reference power level. If the output power level is too high, the APC algorithm can reduce the gain of amplifier 50. If the output power level is too low, the APC algorithm can increase the gain of amplifier 50.

Power detector 70-RX can be used to detect or measure an output power level of radio-frequency signals generated at the output of receiving amplifier circuitry 52. The detected output power level can then be used by an automatic gain control (AGC) algorithm to dynamically adjust the gain of LNA circuitry 52 to ensure that the receive path is outputting signals at desired power levels regardless of the strength of signals arriving at the input of circuitry 52. The AGC algorithm, which can run on processor 26 or other control circuitry in device 10, can be used to ensure that signals are output from circuitry 52 at a constant output power level. If the input signal is weak, the AGC algorithm can increase the gain of amplifier 52 to maintain constant output level. If the input signal is strong, then the AGC algorithm can reduce the gain of amplifier 52 to prevent the output level from becoming too high.

The example of FIG. 3 in which power detectors 70-TX and 70-RX are coupled at the radio-frequency amplifier outputs is illustrative. If desired, wireless circuitry 24 may include one or more additional power detectors 70 coupled to one or more points along transmit path 72 and/or receive path 74. For example, one or more power detectors 70 can be coupled at the output of DAC 62, at the output of mixer 64, and/or at any other point(s) along transmit path 72, at the output of mixer 68, at the output of ADC 66, and/or at any other point(s) along the path 74.

In implementations described herein as an example, wireless circuitry 24 may include a power detector 70 that includes a front-end rectifier that converts radio-frequency power to a low frequency differential output voltage, a baseband comparator, and specific absorption rate (SAR) logic that detects threshold crossings. These types of comparator-based power detectors compare the differential reference voltage with different static thresholds. In a mission mode, the rectifier output varies in high dynamic range, which can make the comparator difficult to implement and prone to errors if care is not taken. In addition, for a radio-frequency signal of a constant input power level, the voltage output by the rectifier also varies across process and temperature variations and corners. Further, the rectifier introduces an offset voltage to its output that drifts as temperature changes over time and that can impact the accuracy of the power detector if left unmitigated.

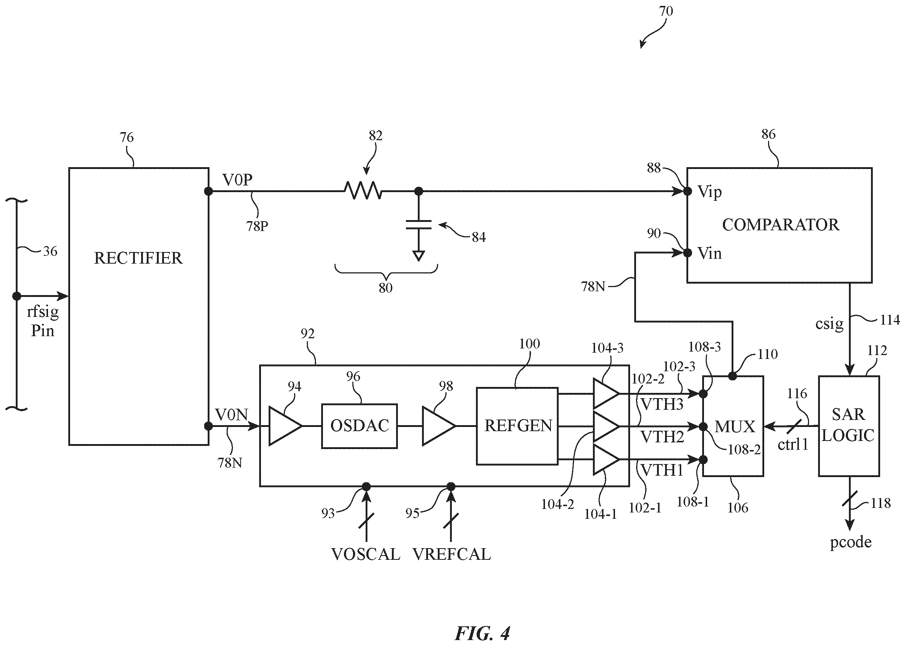

FIG. 4 is a schematic circuit diagram of an illustrative power detector 70 that mitigates these issues. Power detector 70 of FIG. 4 may form power detector 70-TX (FIG. 3), power detector 70-RX (FIG. 3), or another power detector 70 coupled to any desired location along radio-frequency transmission line path 36 (FIG. 2).

As shown in FIG. 4, power detector 70 may include rectifier circuitry such as rectifier 76, comparator circuitry such as comparator 86, baseband circuitry such as compensation circuitry 92, switching circuitry such as multiplexer (MUX) 106 (e.g., a 3-1 MUX), and processing circuitry such as SAR logic 112 (e.g., digital logic forming a portion of control circuitry 14 of FIG. 1). Rectifier 76 may have an input coupled to radio-frequency transmission line path 36. Rectifier 76 may have first and second output terminals that are communicatively coupled to respective first and second input terminals of comparator 86 over differential signal path 78. Differential signal path 78 includes a first (positive) signal line 78P and a second (negative) signal line 78N.

Signal line 78P may couple the first output terminal of rectifier 76 to a first input terminal 88 of comparator 86 (e.g., a positive input terminal of comparator 86). Signal line 78N may couple the second output terminal of rectifier 76 to a second input terminal 90 of comparator 86 (e.g., a negative input terminal of comparator 86). Signal lines 78P and 78N form a differential pair of signal lines and convey a differential signal. The differential signal may be characterized by a positive voltage V0P on signal line 78P and a corresponding negative voltage V0N on signal line 78N.

Compensation circuitry 92 and multiplexer 106 may be disposed on signal line 78N (e.g., multiplexer 106 may be coupled in series between compensation circuitry 92 and comparator 86 on signal line 78N). Compensation circuitry 92 may include an input amplifier such as amplifier 94, an offset calibration digital-to-analog converter (OSDAC), reference (threshold) generation circuitry such as reference (threshold) generator (REFGEN) 100, an inter-stage amplifier such as amplifier 98, and a set of N output amplifiers such as amplifiers 104. OSDAC 96 may be coupled in series between amplifier 94 and amplifier 98 on signal line 78N. Amplifier 98 may be coupled in series between OSDAC 96 and reference generator 100 on signal line 78N. Reference generator 100 may have a set of N outputs that are each coupled to multiplexer 106 over a respective signal line 102. A respective amplifier 104 may be disposed on each of the signal lines 102 between reference generator 100 and multiplexer 106.

Multiplexer 106 may have N input terminals (ports) 108. Each input terminal 108 is coupled to a respective signal line 102. Signal lines 102 may be coupled in parallel between multiplexer 106 and reference generator 100. Multiplexer 106 also has an output terminal (port) 110 coupled to the second input terminal 90 of comparator 86. Multiplexer 106 may have a control terminal (port) coupled to SAR logic 112 over control path 116 (e.g., a digital control path). Multiplexer 106 may couple a selected one of its N input terminals 108 to its output terminal 110 based on a control signal ctrl1 (e.g., a digital control signal) received from SAR logic 112 over control path 116. Control signal ctrl1 may switch multiplexer 106 between different switch states over time, controlling multiplexer 106 to adjust which of its N input terminals 108 is coupled to comparator 86 via output terminal 110 over time.

N may be any integer greater than or equal to one. N may correspond to the number of different threshold voltages VTH producible by reference generator 100 and provided to input terminal 90 of comparator 86 via multiplexer 106. In the example of FIG. 4, there are N = 3 outputs of reference generator 100 coupled to N = 3 signal lines 102 (e.g., a first signal line 102-1, a second signal line 102-2, and a third signal line 102-3), there are N amplifiers 104 disposed on signal lines102 (e.g., a first amplifier 104-1 disposed on signal line 102-1, a second amplifier 104-2 disposed on signal line 102-2, and a third amplifier 104-3 disposed on signal line 102-3), and multiplexer 106 has N = 3 inputs terminal 108 (e.g., a first input terminal 108-1 coupled to signal line 102-1, a second input terminal 108-2 coupled to signal line 102-2, and a third input terminal 108-3 coupled to signal line 102-3).

Reference generator 100 may generate, output, and/or produce a respective threshold voltage VTH on each of signal lines 102 (e.g., a first threshold voltage VTH1 on signal line 102-1, a second threshold voltage VTH2 on signal line 102-2, and a third signal path VTH3 on signal line 102-3). Multiplexer 106 may provide a selected one of threshold voltages VTH to input terminal 90 of comparator 86 at a given time (e.g., based on control signal ctrl1, which controls multiplexer 106 to couple a selected one of its input terminals 108 and thus a selected one of signal lines 102 to its output terminal 110 and thus input terminal 90 of comparator 86). This example is illustrative and non-limiting. In general, N may be equal to two, N may be equal to one, N may be equal to four, or N may be equal to more than four (e.g., compensation circuitry 92 may provide any desired number N of different threshold voltages VTH to input terminal 90 of comparator 86).

Power detector 70 may also include a filter disposed on signal line 78P such as low pass filter (LPF) 80. LPF 80 may include, as one example, a resistor 82 coupled in series along signal line 78P and a shunt capacitor 84 coupled between signal line 78P and ground. LPF 80 may help to reduce high frequency common mode (CM) from the signal provided to comparator 86.

When radio-frequency signal rfsig propagates along radio-frequency transmission line path 36, at least some of the radio-frequency signal may be tapped off of radio-frequency transmission line path 36 (e.g., by a signal splitter, a signal coupler, a transformer, etc.) and provided to the input of rectifier 76. Rectifier 76 receives radio-frequency signal rfsig at power level Pᵢₙ. Power detector 70 may measure or estimate the power level Pᵢₙ of radio-frequency signal rfsig. SAR logic 112 may generate a digital output such as power code pcode (e.g., a three-bit power code) that characterizes or identifies the measured power level Pᵢₙ of radio-frequency signal rfsig.

Rectifier 76 may include square law devices and/or other rectifier circuits that rectify the radio-frequency signal rfsig received at its input, which converts radio-frequency rfsig into a lower frequency differential output voltage, represented by voltage V0P on signal line 78P and voltage V0N on signal line 78N. Signal line 78P carries voltage V0P to input terminal 88 of comparator 86 (e.g., through LPF 80). LPF 80 may remove CM noise from voltage V0P to help prevent false detections by comparator 86. Comparator 86 may receive voltage V0P at a corresponding voltage level Vᵢₚ. Compensation circuitry 92 may receive voltage V0N. Amplifier 94 may amplify voltage V0N (e.g., to a level suitable for subsequent processing by OSDAC 96).

In practice, rectifier 76 introduces a non-zero offset voltage into voltage V0P/V0N. The non-zero offset voltage causes voltage V0P/V0N to have a non-zero magnitude even when the power level Pᵢₙ of radio-frequency signal rfsig is equal to zero. The magnitude of the offset voltage varies over time as a function of the temperature of wireless circuitry 24 as well as between devices 10 due to device-to-device process variation. If the offset voltage is not suitably compensated for, power detector 70 can exhibit insufficient accuracy in measuring power level Pᵢₙ.

In some implementations, compensation circuitry 92 includes fixed circuitry that always adds the same constant (static) DC voltage to the voltage V0N on signal line 78N to help mitigate the offset voltage introduced by rectifier 76. However, this type of circuitry adds same DC voltage to voltage V0N even after the actual offset of rectifier 76 has changed due to a change in the temperature of device 10. This can prevent the compensation circuitry 92 from fully compensating for the actual offset voltage, limiting the accuracy with which power detector 70 measures radio-frequency signal rfsig.

To mitigate these issues, OSDAC 96 may add a dynamic offset voltage VOS to voltage V0N to shift the magnitude of voltage V0N up or down (e.g., by offset voltage VOS) in a manner that fully compensates for the actual offset introduced by rectifier 76. Compensation circuitry 92 may receive an offset calibration signal VOSCAL (e.g., a digital offset calibration signal) over control terminal 93 (e.g., a digital control port of compensation circuitry 92). Offset calibration signal VOSCAL may control OSDAC 96 to dynamically switch, scan, sweep, or search through different offset voltages VOS applied to voltage V0N until the actual offset introduced by rectifier 76 has been fully canceled out by offset voltage VOS.

If desired, offset calibration signal VOSCAL may also control compensation circuitry 92 to perform an offset (OSDAC) calibration operation that serves to map different settings or codes of OSDAC 96 to different magnitudes of offset voltage VOS to help ensure that the correct offset voltage VOS is added to voltage V0N while measuring radio-frequency signal rfsig. In this way, OSDAC 96 may produce an offset-compensated voltage (sometimes denoted herein as V0N + VOS) and may provide the offset-compensated voltage to reference generator 100. Amplifier 98 may amplify the offset-compensated voltage output by OSDAC 96 (e.g., to a level suitable for subsequent processing by reference generator 100). The offset-compensated voltage is sometimes also referred to herein as an offset-mitigated voltage (e.g., having magnitude V0N + VOS).

Reference generator 100 may use the offset-compensated voltage received from OSDAC 96 to generate the N threshold voltages VTH output onto signal lines 102. Each threshold voltage VTH may include a different respective threshold voltage VREF that reference generator 100 adds to the offset-compensated voltage received from OSDAC 96 (e.g., threshold voltage VTH1 may be equal to the offset-mitigated voltage plus a first threshold voltage VREF 1, threshold voltage VTH2 may be equal to the offset-mitigated voltage plus a second threshold voltage VREF2, and threshold voltage VTH3 may be equal to the offset-mitigated voltage plus a third threshold voltage VREF3). If desired, reference generator 100 may generate reference voltages VREF (e.g., for inclusion in threshold voltages VTH) based on the present temperature of wireless circuitry 24 in a manner that helps to mitigate the effect of temperature variation on the operation of power detector 70. Compensation circuitry 92 may receive a reference (threshold) calibration signal VREFCAL (e.g., a digital reference calibration signal) over control terminal 96 (e.g., a digital control port of compensation circuitry 92). Reference calibration signal VREFCAL may control reference generator 100 to dynamically switch, scan, sweep, or search through different threshold voltages VREF that are included in each threshold voltage VTH output by reference generator 100.

If desired, reference calibration signal VREFCAL may also control compensation circuitry 92 to perform a threshold calibration operation that serves to map different settings or codes of reference generator 100 to different magnitudes of the reference voltages VREF included in threshold voltages VTH. This may, for example, help to ensure that the correct reference voltage is added to the offset-compensated voltage given the present temperature of wireless circuitry 24. In this way, reference generator 100 may produce offset and temperature-compensated threshold voltages VTH and may provide the threshold voltages to respective inputs 108 of multiplexer 106 via signal lines 102. Amplifiers 104 may amplify the threshold voltages VTH output by reference generator 100 (e.g., to levels suitable for comparison to voltage V0P by comparator 86, to mitigate headroom issues, etc.).

SAR logic 112 may use control signal crtrl1 to control multiplexer 106 to rapidly switch (toggle) between providing different threshold voltages VTH from different input terminals 108 to its output terminal 110 and thus input terminal 90 of comparator 86 while comparator 86 concurrently receives voltage V0P at input terminal 88. The magnitude of the threshold voltages VTH as received at input terminal 90 is characterized by voltage level Vᵢₙ. Comparator 86 may compare the voltage level at input terminal 88 (Vᵢₚ) to the voltage level at input terminal 90 (Vᵢₙ) to produce a corresponding comparator signal csig on comparator output path 114. Comparator 86 may provide comparator signal csig to SAR logic 112 over comparator output path 114. Comparator signal csig may have a first logical value when the magnitude of voltage level Vᵢₚ exceeds the magnitude of voltage level Vᵢₙ and may have a second logical value when the magnitude of voltage level Vᵢₙ exceeds the magnitude of voltage level Vᵢₚ.

If desired, SAR logic 112 may adjust the state of multiplexer 106 (e.g., the particular threshold(s) VTH provided to input terminal 90 of comparator 86) based on comparator signal csig. For example, SAR logic 112 may control multiplexer 106 to provide suitable threshold(s) VTH to comparator 86 for comparator 86 to compare to voltage V0P for the corresponding power level Pᵢₙ of radio-frequency signal rfsig (e.g., such that higher thresholds VTH are used when power level Pᵢₙ is relatively high and lower thresholds VTH are used when power level Pᵢₙ is relatively low). SAR logic 112 may also output a power code pcode based on comparator signal csig and the corresponding thresholds VTH used to produce comparator signal csig, which are known to SAR logic 112 because SAR logic 112 uses control signal ctrl1 to control which thresholds VTH are applied to comparator 86 by multiplexer 106 over time.

Power code pcode may include or identify the power level Pᵢₙ or a range of powers that contains power level Pᵢₙ. In one example, power code pcode may be a three-bit power code. In this example, SAR logic 112 may output power code pcode as a first digital value such as "000" if/when power level Pᵢₙ is measured via comparator 86 to be within a first range of powers (e.g., less than -22 dBm), as a second digital value such as "001" (e.g., where "1" is the least significant bit (LSB) and the first "0" is the most significant bit (MSB) of the power code) if/when power level Pᵢₙ is measured via comparator 86 to be within a second range of powers (e.g., less than greater than -22 dBm and less than -16 dBm), as a third digital value such as "011" if/when power level Pᵢₙ is measured via comparator 86 to be within a third range of powers (e.g., less than greater than -16 dBm and less than -10 dBm), and as a fourth digital value such as "111" if/when power level Pᵢₙ is measured via comparator 86 to be within a fourth range of powers (e.g., less than greater than -10 dBm). This example is illustrative and non-limiting. SAR logic 112 may output power codes pcode having any desired number of bits used to identify power level Pᵢₙ with any desired level of precision. SAR logic 112 may output power code pcode to other processing circuitry in device 10 (e.g., control circuitry 14 of FIG. 1). The processing circuitry may perform any desired action based on power code pcode and the measured power level Pᵢₙ of radio-frequency signal rfsig. Power code pcode is sometimes also referred to herein as thermal code pcode.

In this way, power detector 70 may use comparator signal csig to perform offset cancellation across temperature and threshold trimmings to remove the impact of comparator offset on power detection accuracy. Supplying offset-compensated threshold voltages such as threshold voltages VTH directly to input terminal 90 of comparator 86 may allow comparator 86 to be implemented as a two-input comparator with a limited input range without sacrificing measurement accuracy.

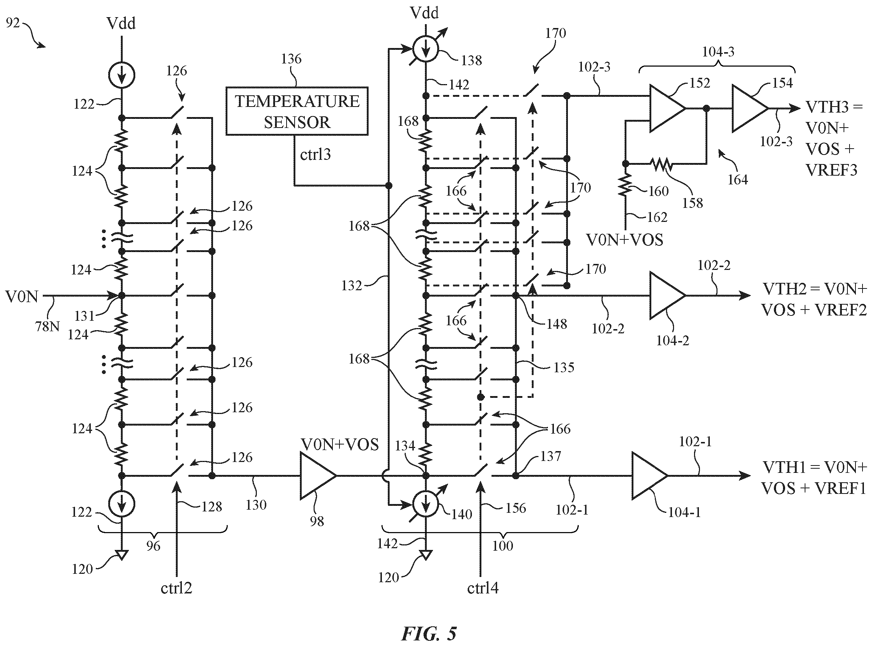

FIG. 5 is a circuit diagram illustrating one example of how OSDAC 96 and reference generator 100 may be implemented in compensation circuitry 92. In the example of FIG. 5, OSDAC 96 is implemented as a first resistive DAC (RDAC) and reference generator 100 is implemented as a second RDAC. This is illustrative and, if desired, OSDAC 96 and/or reference generator 100 may be implemented using other circuit architectures.

As shown in FIG. 5, OSDAC 96 may include a resistor line 122 coupled between a power supply voltage Vdd and a reference voltage such as ground 120. OSDAC 96 may include a set of resistors 124 coupled in series along resistor line 122. The input of OSDAC 96 may be formed from a node 131 on resistor line 122 that receives the voltage V0N on signal line 78N. The output of OSDAC 96 may be coupled to the input of amplifier 98 over signal line 130.

OSDAC 96 may include a set of switches 126 coupled between different nodes on resistor line 122 and signal line 130 (e.g., in parallel). In a simplest case, each switch 126 may be implemented using a respective transistor having a first source-drain terminal coupled to resistor line 122, a second source-drain terminal coupled to signal line 130, and a gate terminal coupled to control line 128. The terms "source" and "drain" are sometimes used interchangeably when referring to current-conducting terminals of a metal-oxide-semiconductor transistor. The source and drain terminals are therefore sometimes referred to as "source-drain" terminals (e.g., a transistor has a gate terminal, a first source-drain terminal, and a second source-drain terminal). Each resistor 124 may have respective first and second switches 126 coupled to resistor line 122 on either side of that resistor 124.

OSDAC 96 may receive a control signal ctrl2 (e.g., a digital control signal) over control line 128 (e.g., a digital control path). Control signal ctrl2 may turn different groups, sets, or combinations of switches 126 on or off. When a switch is on, active, closed, or enabled, current flows between the source-drain terminals of the switch (e.g., from resistor line 122 onto signal line 130). The particular group of switches 126 that are turned on may couple a corresponding number of resistors 124 between power supply voltage Vdd and signal line 130, causing OSDAC 96 to add a corresponding offset voltage VOS to input voltage V0N (e.g., where a different number of active switches 126 causes a different number of resistors 124 to be active in the OSDAC, causing a different magnitude of offset voltage VOS to be added to the input voltage V0N).

Control signal ctrl2 may set offset voltage VOS to be equal (or as close to equal as achievable) but opposite to the offset actually imparted to voltage V0N by rectifier 76 given the present operating conditions of power detector 70 (e.g., offset voltage VOS may have equal magnitude but opposite sign relative to the offset voltage produced by rectifier 76). Control signal ctrl2 may include a control signal in offset calibration signal VOSCAL (FIG. 4), control signal ctrl2 may be generated by control circuitry or interface circuitry based on offset calibration signal VOSCAL, and/or the particular values (digital codes) carried by control signal ctrl2 may be calibrated using offset calibration signal VOSCAL. The value of offset voltage VOS is dynamic and may be updated (e.g., using control signal ctrl2) over time as the operating conditions of device 10 change over time.

After adding the correct offset voltage VOS to voltage V0N, OSDAC 96 outputs the added signal onto signal line 130 as an offset-compensated voltage with a magnitude equal to V0N + VOS. Amplifier 98 may amplify the offset-compensated voltage if desired. Reference generator 100 may receive the offset-compensated voltage from amplifier 98 over signal line 130.

Reference generator 100 may include a resistor line 142 coupled between power supply voltage Vdd and a reference voltage such as ground 120. Reference generator 100 may include a set of resistors 168 coupled in series along resistor line 142. The input of reference generator 100 may be formed from a node 134 on resistor line 142 that is coupled to signal line 130 and that receives the offset-compensated voltage via signal line 130. Reference generator 100 may include a first adjustable current source 138 coupled in series on resistor line 142 between resistors 168 and power supply voltage Vdd. Reference generator 100 may include a second adjustable current source 140 coupled in series on resistor line 142 between resistors 168 and ground 120.

Reference generator 100 may include a set of switches 166 coupled between nodes on resistor line 142 and signal line 135 (e.g., switches 166 may be coupled in parallel between signal path 135 and resistor line 142). Each resistor 168 may have respective first and second switches 166 coupled to resistor line 142 on either side of that resistor 168. Signal line 102-1 may be coupled to a first node 137 on signal path 135 (e.g., forming a first output of reference generator 100). Signal line 102-2 may be coupled to a second node 148 on signal path 135 (e.g., forming a second output of reference generator 100).

Reference generator 100 may include an additional set of switches 170 coupled in parallel between nodes on resistor line 142 (e.g., fewer nodes than are coupled to switches 166) and signal line 102-3. Switches 170 do not couple resistor line 142 to signal path 135, signal line 102-2, or signal line 102-1. Switches 170 may, for example, be coupled to nodes on resistor line 142 that are between signal line 102-2 and adjustable current source 138 (e.g., switches 170 may switchably couple a subset of the resistors 168 on resistor line 142, such as half of the resistors 168 on resistor line 142, to signal line 102-3).

Reference generator 100 may receive a control signal ctrl4 (e.g., a digital control signal) over control line 156 (e.g., a digital control path). Control signal ctrl4 may turn different groups, sets, or combinations of switches 166 and/or 170 on or off. The particular number of switches 166 that are turned on between node 148 and adjustable current source 138 controls the number of resistors 168 that are switched into use or coupled between adjustable current source 138 and signal line 102-2. This causes reference generator 100 to add a corresponding reference voltage VREF2 to the offset-mitigated signal received from OSDAC 96 (e.g., where the magnitude of reference voltage VREF2 may be changed by adjusting the number of switches 166 that are turned on and thus the number of resistors 168 that are coupled into use between adjustable current source 138 and signal line 102-2). Amplifier 104-2 may amplify this added signal to produce threshold voltage VTH2 on signal line 102-2 (e.g., where VTH2 = V0N + VOS + VREF2).

At the same time, the particular number of switches 166 that are turned on between node 137 and adjustable current source 138 controls the number of resistors 168 that are switched into use or coupled between adjustable current source 138 and signal line 102-1. This causes reference generator 100 to add a corresponding reference voltage VREF1 to the offset-mitigated signal received from OSDAC 96 (e.g., where the magnitude of reference voltage VREF1 may be changed by adjusting the number of switches 166 that are turned on and thus the number of resistors 168 that are coupled into use between adjustable current source 138 and signal line 102-1). Amplifier 104-1 may amplify this added signal to produce threshold voltage VTH1 on signal line 102-1 (e.g., where VTH1 = V0N + VOS + VREF1).

At the same time, the particular number of switches 170 that are turned on controls the number of resistors 168 that are switched into use or coupled between adjustable current source 138 and signal line 102-3. This causes reference generator 100 to add a corresponding reference voltage VREF3 to the offset-mitigated signal received from OSDAC 96 (e.g., where the magnitude of reference voltage VREF3 may be changed by adjusting the number of switches 170 that are turned on and thus the number of resistors 168 that are coupled into use between adjustable current source 138 and signal line 102-3). Amplifier 104-4 may amplify this added signal to produce threshold voltage VTH3 on signal line 102-3 (e.g., where VTH3 = V0N + VOS + VREF3). Reference voltage VREF3 has a larger magnitude than reference voltage VREF2. Reference voltage VREF2 has a larger magnitude than reference voltage VREF1. If desired, reference generator 100 may be generalized to produce N different reference voltages of different magnitudes for comparator 86 to use in detecting crossing points of voltage V0P.

Amplifier 104-4 may include one or more amplifier stages. If desired, amplifier 104-3 may include a first amplifier 154 and a second amplifier 152 having an output coupled to the input of amplifier 154. Amplifier 152 may be, for example, an operational amplifier having a first input coupled to switches 170 and having a second input coupled to its output through resistor 158. An additional resistor such as resistor 160 may couple resistor 158 and the second input of amplifier 152 to signal line 162. Resistor 158 may, for example, have a higher resistance than resistor 160. Signal line 162 may be coupled to signal line 130. Signal line 162 may carry the offset-compensated voltage (VON + VOS) to amplifier 152 through resistor 160. Amplifier 152, resistor 158, and resistor 160 may collectively form an attenuation circuit 164. Attenuation circuit 164 may, for example, attenuate the signal received from switches 170 to provide additional headroom for amplifier 154 (e.g., preventing the signal from saturating amplifier 154 given that reference voltage VREF3 has the highest magnitude of the reference voltages produced by reference generator 100, which may help to maintain power detection accuracy).

Compensation circuitry 92 may also include temperature sensor circuitry such as temperature sensor 136. Temperature sensor 136 may generate temperature sensor data indicative of the temperature of one or more locations in compensation circuitry 92, power detector 70, wireless circuitry 24 (FIG. 1), and/or device 10. If desired, some or all of the components of power detector 70 may be integrated into a shared substrate such as a single integrated circuit chip. Temperature sensor 136 may, for example, measure the temperature of one or more locations on the integrated circuit chip.

Temperature sensor 136 may be coupled to control inputs of adjustable current sources 138 and 140 over control path 132. Temperature sensor 136 may provide a control signal ctrl3 to adjustable current sources 138 and 140 over control path 132. Control signal ctrl3 may control, set, and/or adjust (e.g., dynamically change) the amount of current produced by adjustable current sources 138 and 140 through resistor line 142 based on the temperature sensor data generated by temperature sensor 136 (e.g., based on the temperature of power detector 70). This may help to tweak or adjust the reference voltages VREF1, VREF2, and VREF3 included in threshold voltages VTH1, VTH2, and VTH3 to compensate for any drift or offset associated with temperature variations in the power detector.

Control signal ctrl4 may include a control signal in reference calibration signal VREFCAL (FIG. 4), control signal ctrl4 may be generated by control circuitry or interface circuitry based on reference calibration signal VREFCAL, and/or the particular values (digital codes) carried by control signal ctrl4 may be calibrated using reference calibration signal VREFCAL. The value of each reference voltage VREF and thus each threshold voltage VTH is dynamic and may be updated (e.g., using control signal ctrl4) over time as the operating conditions of device 10 change over time. Control signal ctrl3 may also be calibrated using reference calibration signal VREFCAL if desired (e.g., to map particular digital codes in control signal ctrl3 to particular current levels produced by adjustable current sources 138 and 140 that would mitigate the effects of changing temperature in power detector 70).

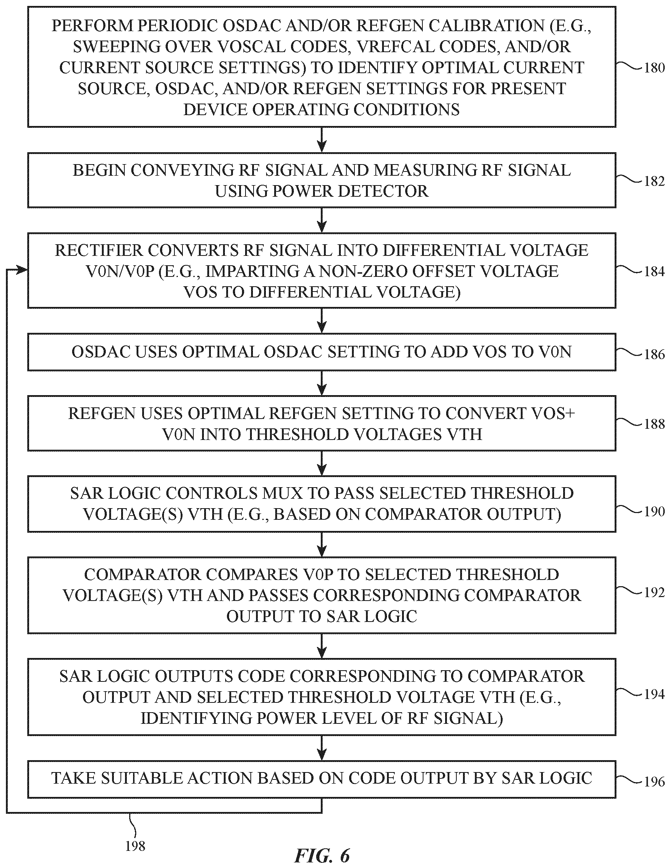

FIG. 6 is a flow chart of illustrative operations involved in measuring a radio-frequency signal using power detector 70. At operation 180, power detector 70 may perform a calibration of OSDAC 96 (e.g., mapping control codes and OSDAC settings/switch configurations to particular offset voltages VOS to use for mitigating offset voltages produced by rectifier 76 even as the offset voltages produced by rectifier 76 change over time). Additionally or alternatively, power detector 70 may perform a calibration of reference generator 100 (e.g., mapping control codes, REFGEN settings/switch configurations, and/or current source settings to particular reference voltages VREF to include in threshold voltages VTH even as the thermal conditions of power detector 70 change over time). Power detector 70 may perform these calibrations at an initial time (e.g., during device assembly, manufacture, testing, etc.) and/or in the field. If desired, power detector 70 may perform these calibrations periodically over time and/or temperature. If desired, power detector 70 may continue to perform these calibrations during or between one or more iterations of the remaining operations of FIG. 6.

The calibration of OSDAC 96 may produce optimal (calibrated) settings for OSDAC 96 (e.g., codes for controlling switches 126 for the generation of suitable offset voltages VOS as required to mitigate the offset imparted by rectifier 76 given the thermal conditions of power detector 70 and/or process variations). The calibration of reference generator 100 may produce optimal (calibrated) settings for reference generator 100 and adjustable current sources 138 and 140 (e.g., codes for controlling switches 166, switches 170, and/or adjustable current sources 138 and 140 as required to mitigate thermal effects given the thermal conditions of power detector 70 and/or process variations).

At operation 182, radio-frequency transmission line path 36 may begin conveying radio-frequency signal rfsig. Power detector 70 may begin measuring the power level Pᵢₙ of radio-frequency signal rfsig.

At operation 184, rectifier 76 may convert radio-frequency signal rfsig into differential voltage V0P/V0N on signal lines 78P and 78N respectively. Signal line 78P passes voltage V0P to input terminal 88 of comparator 86. LPF 80 may remove CM noise from voltage V0P. Signal line 78N passes voltage V0N to compensation circuitry 92. Rectifier 76 imparts a non-zero offset voltage to the differential voltage. The magnitude of the non-zero offset may vary depending on the temperature of power detector 70 and/or process variations.

At operation 186, OPSDAC 96 may use its optimal (calibrated) settings to add a corresponding offset voltage VOS to voltage V0N that reverses or cancels out the non-zero offset imparted by rectifier 76, producing an offset-compensated voltage (VON + VOS).

At operation 188, reference generator 100 may use its optimal (calibrated) settings to convert the offset-compensated voltage (VON + VOS) into suitable threshold voltages VTH while mitigating thermal/temperature effects (e.g., by adding a suitable reference voltage VREF1 to the offset-compensated voltage to produce threshold voltage VTH1, by adding a suitable reference voltage VREF2 to the offset-compensated voltage to produce threshold voltage VTH2, and by adding a suitable reference voltage VREF3 to the offset-compensated voltage to produce threshold voltage VTH3). Reference generator 100 may provide each generated threshold voltage VTH to a different respective input terminal 108 of multiplexer 106 (FIG. 4) over the corresponding signal line 102.

At operation 190, SAR logic 112 may control multiplexer 106 to pass one or more of the threshold voltages VTH received from reference generator 100 to input 90 of comparator 86 based on the comparator signal csig output by comparator 86. If desired, SAR logic 112 may control multiplexer 106 to rapidly switch or toggle between providing different threshold voltages VTH to comparator 86 over time.

At operation 192, comparator 86 may compare the voltage V0P received at its input terminal 88 to the threshold voltage(s) VTH received from multiplexer 106 to generate/update comparator signal csig. If/when voltage V0P exceeds threshold VTH3, for example, this may be indicative of power level Pᵢₙ being relatively high. If/when voltage V0P does not exceed threshold VTH1, for example, this may be indicative of power level Pᵢₙ being relatively low. Whether or not voltage V0P exceeds different thresholds VTH may be indicative of the range of power levels containing the true power level Pᵢₙ of radio-frequency signal rfsig.

At operation 194, SAR logic 112 may generate power code pcode based on comparator signal csig and the corresponding threshold(s) VTH used to generate comparator signal csig. Power code pcode may, for example, identify or estimate the power level Pᵢₙ of radio-frequency signal rfsig (e.g., as detected using power detector 70). SAR logic 112 may pass power code pcode to other circuitry in device 10 for further processing. SAR logic 112 may also adjust or update the switching of multiplexer 106 based on comparator signal csig. Because CM noise is removed from voltage V0P (e.g., by LPF 80), the particular offset voltage imparted by rectifier 76 (e.g., given the present temperature of power detector 70) is removed by OSDAC 96, and thermal effects are also accounted for in the generation of reference voltages VREF and thus threshold voltages VTH, power code pcode may accurately represent the true power level Pᵢₙ of radio-frequency signal rfsig regardless of the temperature of power detector 70 and any process variations.

At operation 196, device 10 may perform one or more actions based on the power code pcode output by SAR logic 112 (e.g., based on the power level Pᵢₙ of radio-frequency signal rfsig as measured using power detector 70). For example, device 10 may adjust the gain of one or more power amplifiers (e.g., power amplifier circuitry 50 of FIG. 3), may adjust the gain of one or more low noise amplifiers (e.g., low noise amplifier circuitry 52 of FIG. 3), may detect and mitigate an interference or blocker signal present at one or more frequencies in a received radio-frequency signal, may adjust the power level of a transmitted signal to satisfy SAR requirements or regulations imposed on device 10, may adjust an amplifier to maximize linearity and/or efficiency of the amplifier, may adjust antenna tuning, may adjust antenna beamforming, may switch different antennas into or out of use, and/or may perform any other desired actions based on power code pcode. Processing may loop back to operation 184 via path 198 as power detector 70 continues to measure radio-frequency signal rfsig.

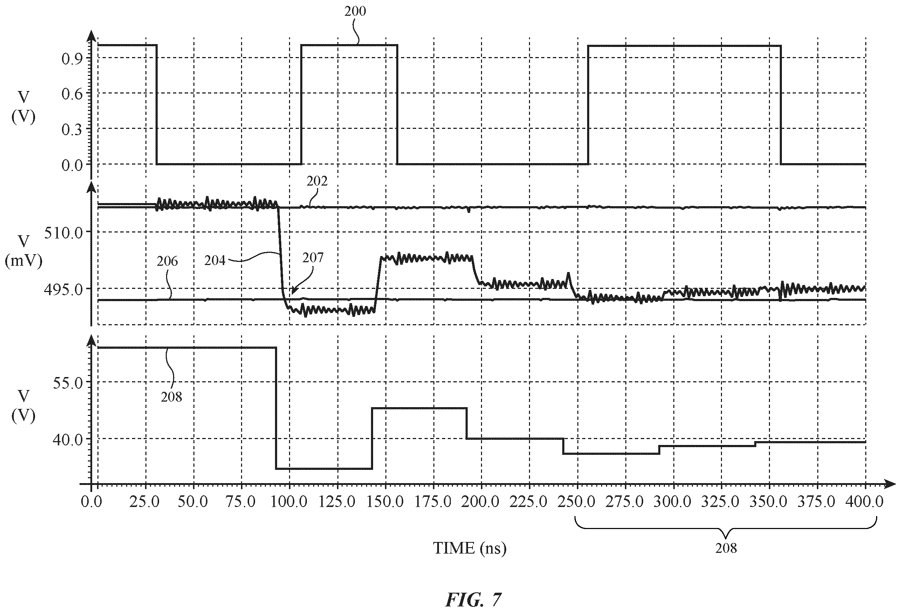

FIG. 7 is a timing diagram illustrating an example of an offset calibration that may be performed to calibrate OSDAC 96 (e.g., while processing operation 180 of FIG. 6). Curve 200 illustrates the comparator signal csig output by comparator 86. Curve 202 illustrates the magnitude of reference voltage VREF1. Curve 206 plots the voltage Vᵢₚ received at input terminal 88 of comparator 86. Curve 206 plots the voltage Vᵢₙ received at input terminal 90 of comparator 86. Curve 208 plots the offset calibration signal VOSCAL provided to compensation circuitry 92.

During offset calibration, compensation circuitry 92 and multiplexer 106 may be set (e.g., using a first digital control code) to produce a single constant reference voltage VREF1 that is provided to input terminal 90 of comparator 86 as a part of threshold voltage VTH1. A binary search procedure may be used to find the particular code for offset calibration signal VOSCAL to use based on the output state of comparator 86. For example, offset calibration signal VOSCAL may switch codes just before 100 ns, changing the magnitude of the offset voltage VOS added to voltage V0N by OSDAC 96. This causes the magnitude of the threshold voltage VTH1 output by reference generator 100 (which is equal to V0N + VOS + VREF1) and thus the voltage Vᵢₙ received at input terminal 90 to change, as shown by drop 207 in curve 204. The binary search continues to sweep through codes of offset calibration signal VOSCAL until voltage Vᵢₙ and thus comparator signal csig (curve 200) settles at a particular magnitude. Once this occurs, the code of offset calibration signal VOSCAL also settles onto a calibrated code for offset calibration signal VOSCAL (e.g., as shown during time period 208), corresponding to the particular offset voltage VOS for OSDAC 96 to use given the current operating conditions of power detector 70.

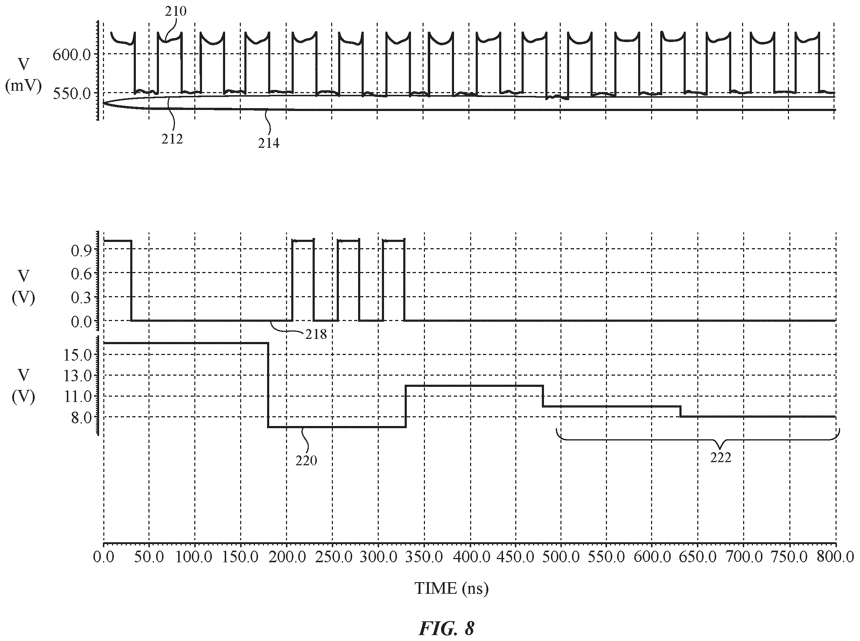

FIG. 8 is a timing diagram illustrating an example of a reference voltage calibration that may be performed to calibrate reference generator 100 (e.g., while processing operation 180 of FIG. 6). Curve 218 illustrates the comparator signal csig output by comparator 86. Curve 214 illustrates the magnitude of reference voltage VREF1. Curve 212 plots the voltage Vᵢₚ received at input terminal 88 of comparator 86. Curve 210 plots the voltage Vᵢₙ received at input terminal 90 of comparator 86. Curve 220 plots the reference calibration signal VREFCAL provided to compensation circuitry 92.

During this calibration, sometimes also referred to as threshold trimming, the input terminal 90 of comparator 86 is rapidly switched between two neighboring references. A binary search procedure is then performed to identify the code for reference calibration signal VREFCAL to use for the current device operating conditions based on the output of SAR Logic 112. A period of about three times the clock period of the power detector may be used for the SAR logic to settle. Once this occurs, the code of reference calibration signal VREFCAL also settles onto a calibrated code for reference calibration signal VREFCAL (e.g., as shown during time period 208), corresponding to the particular reference voltages VREF for reference generator 100 to use given the current operating conditions of power detector 70.

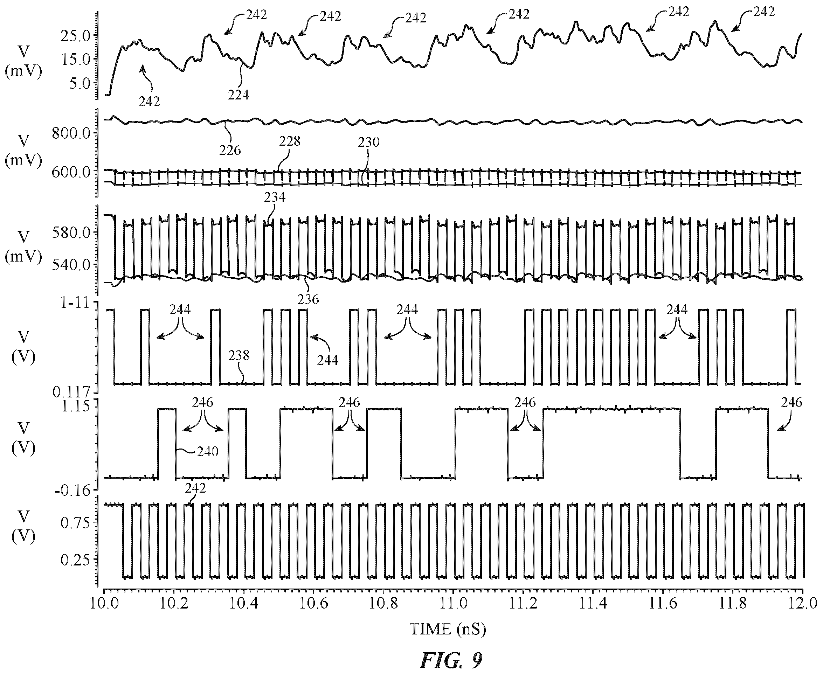

FIG. 9 is a timing diagram illustrating one example of how power detector 70 may measure the power Pᵢₙ of radio-frequency signal rfsig. Curve 224 plots the magnitude of the radio-frequency signal rfsig received by power detector 70 (e.g., while conveying OFDM waveforms). Curve 226 plots threshold voltage VTH3. Curve 228 plots threshold voltage VTH2. Curve 230 plots threshold voltage VTH1. Curve 234 plots the voltage Vᵢₙ received at input terminal 90 of comparator 86. Curve 236 plots the voltage Vᵢₚ received at input terminal 88 of comparator 86. Curve 238 plots the comparator signal csig output by comparator 86. Curve 240 plots a particular code of the power code pcode output by SAR logic 112. Curve 242 illustrates the clock signal used to clock power detector 70.

As shown by curve 224, the power Pᵢₙ of radio-frequency signal rfsig may vary over time. As shown by curve 234, multiplexer 106 may switch or toggle between providing different threshold voltages VTH to input terminal 90 of comparator 96 for comparison to voltage Vᵢₚ. As shown by peaks 244 in curve 238, peaks 242 in the power level Pᵢₙ may cause comparator 86 to output corresponding pulses 244 in comparator signal csig. As shown by curve 240, SAR logic 112 may output the corresponding power code pcode (e.g., a particular power code corresponding to the range of power levels Pᵢₙ containing the power level of peaks 242 in curve 224) responsive to the occurrence of peaks 244 in curve 238. This example is illustrative and non-limiting.

The methods and operations described above in connection with FIGS. 1-9 may be performed by the components of device 10 using software, firmware, and/or hardware (e.g., dedicated circuitry or hardware). Software code for performing these operations may be stored on non-transitory computer readable storage media (e.g., tangible computer readable storage media) stored on one or more of the components of device 10 (e.g., storage circuitry 16 and/or wireless communications circuitry 24 of FIG. 1). The software code may sometimes be referred to as software, data, instructions, program instructions, or code. The non-transitory computer readable storage media may include drives, non-volatile memory such as non-volatile random-access memory (NVRAM), removable flash drives or other removable media, other types of random-access memory, etc. Software stored on the non-transitory computer readable storage media may be executed by processing circuitry on one or more of the components of device 10 (e.g., processing circuitry in wireless circuitry 24, processing circuitry 18 of FIG. 1, etc.). The processing circuitry may include microprocessors, application processors, digital signal processors, central processing units (CPUs), application-specific integrated circuits with processing circuitry, or other processing circuitry.

For one or more aspects, at least one of the components set forth in one or more of the preceding figures may be configured to perform one or more operations, techniques, processes, or methods as set forth in the example section below.

### Examples

In the following sections, further exemplary aspects are provided.

Example 1 includes wireless circuitry including: a radio-frequency transmission line configured to convey a radio-frequency signal; and a power detector operably coupled to the radio-frequency transmission line and configured to measure a power of the radio-frequency signal, the power detector including a rectifier configured to convert the radio-frequency signal into a differential voltage including a first voltage on a first signal line and a second voltage on a second signal line; a comparator having a first input coupled to the rectifier over the first signal line and having a second input coupled to the rectifier over the second signal line, and
a digital-to-analog converter (DAC) disposed on the second signal line, the DAC being configured to add a dynamic offset voltage to the second voltage that changes over time.

Example 2 includes the wireless circuitry of example 1, wherein the DAC optionally comprises a resistive DAC (RDAC).

Example 3 includes the wireless circuitry of example 2, wherein the RDAC optionally includes: a resistor line coupled between a power supply voltage and a ground voltage; and a set of switches coupled in parallel between nodes on the resistor line and a third signal line.

Example 4 includes the wireless circuitry of example 3, further optionally including one or more processors configured to: provide the dynamic offset voltage with a first magnitude at a first time by turning on a first set of the switches; and provide the dynamic offset voltage with a second magnitude at a second time by turning on a second set of the switches, the second magnitude being different than the first magnitude.

Example 5 includes the wireless circuitry of example 3, further optionally including: an additional RDAC operably coupled between the third signal line and the second input of the comparator.

Example 6 includes the wireless circuitry of example 5, further optionally including a multiplexer operably coupled between the additional RDAC and the second input of the comparator.

Example 7 includes the wireless circuitry of example 9, wherein the multiplexer optionally has a first input terminal coupled to the additional RDAC over a fourth signal line, a second input terminal coupled to the additional RDAC over a fifth signal line, and a third input terminal coupled to the additional RDAC over a sixth signal line.

Example 8 includes the wireless circuitry of example 7, wherein the additional RDAC is optionally configured to generate: a first threshold voltage on the fourth signal line by adding a first reference voltage to the second voltage and the dynamic offset voltage, a second threshold voltage on the fifth signal line by adding a second reference voltage to the second voltage and the dynamic offset voltage, and a third threshold voltage on the sixth signal line by adding a third reference voltage to the second voltage and the dynamic offset voltage.

Example 9 includes the wireless circuitry of example 8, further optionally including digital logic operably coupled to the comparator and the multiplexer, wherein the comparator is optionally configured to generate a comparator signal based on the first voltage and the first, second, and third threshold voltages, the digital logic being configured to adjust the multiplexer based on the comparator signal.

Example 10 includes the wireless circuitry of example 9, further optionally including an amplifier on the radio-frequency transmission line path; and one or more processors, wherein the digital logic is optionally configured to output a digital code based on the comparator signal, the digital code characterizing the power of the radio-frequency signal, and the one or more processors being configured to adjust a gain of the amplifier based on the digital code.

Example 11 includes the wireless circuitry of example 8, further optionally including: a temperature sensor configured to measure a temperature of the rectifier, the additional RDAC being configured to adjust the first, second, and third reference voltages based on the temperature of the rectifier.

Example 12 includes the wireless circuitry of example 1, further optionally including: a low pass filter disposed on the first signal line and configured to reduce a common mode noise of the first voltage.

Example 13 includes a power detector configured to measure a power of a radio-frequency signal, including: a rectifier configured to receive the radio-frequency signal; a comparator having a first input coupled to the rectifier over a first signal line and having a second output coupled to the rectifier over a second signal line, the rectifier being configured to output a first voltage on the first signal line and a second voltage on the second signal line; and
a digital-to-analog converter (DAC) on the second signal line, the DAC being configured to add a first offset voltage to the second voltage at a first time, and add a second offset voltage to the second voltage at a second time, the second offset voltage being different than the first offset voltage.

Example 14 includes the power detector of example 13, further optionally including a reference generator disposed on the second signal line between the DAC and the second input of the comparator.

Example 15 includes the power detector of example 14, further optionally including a multiplexer disposed on the second signal line between the reference generator and the second input of the comparator.

Example 16 includes the power detector of example 15, further optionally including: digital logic coupled to an output of the comparator and configured to control the multiplexer to route different threshold voltages produced by the reference generator to the second input of the comparator.

Example 17 includes the power detector of example 16, wherein the digital logic is optionally configured to output a digital code that identifies the measured power of the radio-frequency signal.

Example 18 includes the power detector of example 14, wherein an output of the DAC is optionally communicatively coupled to an input of the reference generator over a third signal line, the DAC optionally including: a set of resistors coupled in series between a power supply voltage and a ground voltage; and a set of switches that couple nodes between the resistors in the set of resistors to the third signal line in parallel.

Example 19 includes the power detector of example 13, further optionally including: a temperature sensor configured to measure a temperature of the power detector, the DAC being configured to add the first offset voltage to the second voltage while the temperature has a first value, and the DAC being configured to add the second offset voltage to the second voltage while the temperature has a second value different than the first value.

Example 20 includes a power detector configured to measure a power of a signal, including: a rectifier configured to receive the signal; a first signal line coupled to a first output of the rectifier; a second signal line coupled to a second output of the rectifier; a comparator having a first input coupled to the first signal line and having a second input coupled to the second signal line; a digital-to-analog converter (DAC) on the second signal line; a reference generator on the second signal line between the DAC and the second input of the comparator; a multiplexer on the second signal line between the reference generator and the second input of the comparator; digital logic operably coupled to the comparator and the multiplexer and configured to output a digital code indicative of the measured power; and a low pass filter on the first signal line.

Example 21 includes wireless circuitry including: a transmission line configured to convey a radio-frequency signal; and a power detector operably coupled to the transmission line and configured to measure a power of the radio-frequency signal, the power detector including a rectifier configured to convert the radio-frequency signal into a differential voltage including a first voltage on a first signal line and a second voltage on a second signal line; a comparator having a first input coupled to the rectifier over the first signal line and having a second input coupled to the rectifier over the second signal line, a reference generator disposed on the second signal line, wherein the reference generator is configured to generate a threshold voltage based on the second voltage and the comparator is configured to compare the first voltage to the threshold voltage; and a temperature sensor configured to measure a temperature of the power detector, the reference generator being configured to adjust the threshold voltage based on the measured temperature.

Example 22 includes the wireless circuitry of example 21, further optionally including: a multiplexer having first and second inputs coupled to the reference generator and having an output coupled to the second input of the comparator.

Example 23 includes the wireless circuitry of example 22, wherein the reference generator optionally comprises a resistive digital-to-analog converter (RDAC).

Example 24 includes the wireless circuitry of example 23, wherein the RDAC optionally includes: a set of resistors coupled between a power supply voltage and a ground voltage; and a set of switches that couple the set of resistors to a third signal line, the third signal line being coupled to the first input of the multiplexer.

Example 25 includes the wireless circuitry of example 24, further optionally including: an additional set of switches that couple a subset of the set of resistors to a fourth signal line, the fourth signal line being coupled to the second input of the multiplexer.

Example 26 includes the wireless circuitry of example 25, wherein the reference generator is optionally configured to output the threshold voltage onto the third signal line and is configured to output an additional threshold voltage onto the fourth signal line, the additional threshold voltage is optionally greater than the threshold voltage, and the comparator is optionally configured to compare the first voltage to the additional threshold voltage.

Example 27 includes the wireless circuitry of example 26, further optionally including: an offset compensating digital-to-analog converter (OSDAC) on the second signal line between the reference generator and the rectifier, the OSDAC being configured to add an offset voltage to the second voltage to generate an offset-compensated voltage, wherein the reference generator is optionally configured to generate the threshold voltage and the additional threshold voltage based on the offset-compensated voltage.

Example 28 includes the wireless circuitry of example 27, further optionally including: a first amplifier disposed on the third signal line; and a second amplifier disposed on the fourth signal line.

Example 29 includes the wireless circuitry of example 28, further optionally including: a third amplifier disposed on the fourth signal line between the second amplifier and the second input of the multiplexer.

Example 30 includes the wireless circuitry of example 29, wherein the second amplifier optionally has a first input coupled to the additional set of switches, the second amplifier has an output coupled to an input of the third amplifier and a second input of the second amplifier, and the wireless circuitry further optionally includes: a first resistor coupled between the output of the second amplifier and the second input of the second amplifier; and a second resistor that couples the second input of the second amplifier to an output of the OSDAC.

Example 31 includes the wireless circuitry of example 24, further optionally including: a first adjustable current source coupled in series between the set of resistors and a power supply voltage; and a second adjustable current source coupled in series between the set of resistors and a ground voltage.

Example 32 includes wireless circuitry of example 24, wherein the temperature sensor is optionally configured to adjust the first and second adjustable current sources based on the measured temperature.

Example 33 includes the wireless circuitry of example 32, further optionally including: digital logic operably coupled to the comparator and the multiplexer, wherein the comparator is optionally configured to generate a comparator signal based on the first voltage and the threshold voltage, the digital logic being configured to adjust the multiplexer based on the comparator signal.

Example 34 includes the wireless circuitry of example 33, further optionally including: an amplifier on the radio-frequency transmission line path; and one or more processors, wherein the digital logic is optionally configured to output a digital code based on the comparator signal, the digital code characterizing the power of the radio-frequency signal, and the one or more processors being configured to adjust a gain of the amplifier based on the digital code.

Example 35 includes the wireless circuitry of example 21, further optionally including: a low pass filter disposed on the first signal line and configured to reduce a common mode noise of the first voltage.

Example 36 includes a power detector configured to measure a power of a signal, including: a rectifier configured to receive the signal; a comparator having a first input coupled to the rectifier over a first signal line and having a second output coupled to the rectifier over a second signal line, the rectifier being configured to output a first voltage on the first signal line and a second voltage on the second signal line; a digital-to-analog converter (DAC) on the second signal line and configured to generate an offset-compensated voltage by adding an offset voltage to the second voltage; and a reference generator on the second signal line between the DAC and second input of the comparator, wherein the reference generator is configured to generate a first threshold voltage by adding a first reference voltage to the offset-compensated voltage, generate a second threshold voltage by adding a second reference voltage to the offset-compensated voltage, the comparator being configured to compare the first voltage to the first and second threshold voltages, and adjust the second reference voltage over time.

Example 37 includes the power detector of example 16, wherein the reference generator optionally includes: a first adjustable current source; a second adjustable current source; a set of resistors coupled in series between the first and second adjustable current sources; a first set of switches that couple the set of resistors to a third signal path, wherein the reference generator is optionally configured to output the first threshold voltage onto the third signal path; and a second set of switches that couple a subset of the set of resistors to a fourth signal path, wherein the reference generator is configured to output the second threshold voltage onto the fourth signal path, and the reference generator is configured to adjust the second reference voltage over time by adjusting the first and second adjustable current sources.

Example 38 includes the power detector of example 37, further optionally including: a temperature sensor configured to measure a temperature of the power detector, the reference generator optionally being configured to adjust the first and second adjustable current sources based on the measured temperature.

Example 39 includes the power detector of example 38, further optionally including: a multiplexer on the second signal path between the reference generator and the second input of the comparator, wherein the multiplexer optionally has a first input coupled to the third signal path, a second input coupled to the fourth signal path, and an output coupled to the second input of the comparator; and digital logic configured to adjust the multiplexer based on an output of the comparator.

Example 30 includes a power detector configured to measure a power of a signal, including: a rectifier configured to receive the signal; a first signal line coupled to a first output of the rectifier; a second signal line coupled to a second output of the rectifier; a comparator having a first input coupled to the first signal line and having a second input coupled to the second signal line; a reference generator on the second signal line; and a multiplexer on the second signal line between the reference generator and the second input of the comparator, wherein the reference generator includes first and second adjustable current sources, a set of resistors coupled in series between the first and second adjustable current sources, a set of switches that communicatively couple the set of resistors to the multiplexer, an amplifier having a first input coupled to the set of switches and having an output communicatively coupled to the multiplexer, a first resistor that couples the output of the amplifier to a second input of the amplifier, and a second resistor configured to pass an offset-compensated version of the second voltage to the second input of the amplifier.

It is well understood that the use of personally identifiable information should follow privacy policies and practices that are generally recognized as meeting or exceeding industry or governmental requirements for maintaining the privacy of users. In particular, personally identifiable information data should be managed and handled so as to minimize risks of unintentional or unauthorized access or use, and the nature of authorized use should be clearly indicated to users.

The foregoing is merely illustrative and various modifications can be made to the described embodiments. The foregoing embodiments may be implemented individually or in any combination.

Exemplary embodiments are set out in the following items and clauses:

### Items

1. Wireless circuitry comprising:
   a transmission line configured to convey a radio-frequency signal; and
   a power detector operably coupled to the transmission line and configured to measure a power of the radio-frequency signal, the power detector including
      a rectifier configured to convert the radio-frequency signal into a differential voltage including a first voltage on a first signal line and a second voltage on a second signal line;
      a comparator having a first input coupled to the rectifier over the first signal line and having a second input coupled to the rectifier over the second signal line,
      a reference generator disposed on the second signal line, wherein the reference generator is configured to generate a threshold voltage based on the second voltage and the comparator is configured to compare the first voltage to the threshold voltage; and
      a temperature sensor configured to measure a temperature of the power detector, the reference generator being configured to adjust the threshold voltage based on the measured temperature.
2. The wireless circuitry of item 1, further comprising:
   a multiplexer having first and second inputs coupled to the reference generator and having an output coupled to the second input of the comparator.
3. The wireless circuitry of item 2, wherein the reference generator comprises a resistive digital-to-analog converter (RDAC).
4. The wireless circuitry of item 3, wherein the RDAC comprises:
   a set of resistors coupled between a power supply voltage and a ground voltage; and
   a set of switches that couple the set of resistors to a third signal line, the third signal line being coupled to the first input of the multiplexer.
5. The wireless circuitry of item 4, further comprising:
   an additional set of switches that couple a subset of the set of resistors to a fourth signal line, the fourth signal line being coupled to the second input of the multiplexer.
6. The wireless circuitry of item 5, wherein the reference generator is configured to output the threshold voltage onto the third signal line and is configured to output an additional threshold voltage onto the fourth signal line, the additional threshold voltage is greater than the threshold voltage, and the comparator is configured to compare the first voltage to the additional threshold voltage.
7. The wireless circuitry of item 6, further comprising:
   an offset compensating digital-to-analog converter (OSDAC) on the second signal line between the reference generator and the rectifier, the OSDAC being configured to add an offset voltage to the second voltage to generate an offset-compensated voltage, wherein the reference generator is configured to generate the threshold voltage and the additional threshold voltage based on the offset-compensated voltage.
8. The wireless circuitry of item 7, further comprising:
   a first amplifier disposed on the third signal line; and
   a second amplifier disposed on the fourth signal line.
9. The wireless circuitry of item 8, further comprising:
   a third amplifier disposed on the fourth signal line between the second amplifier and the second input of the multiplexer.
10. The wireless circuitry of item 9, wherein the second amplifier has a first input coupled to the additional set of switches, the second amplifier has an output coupled to an input of the third amplifier and a second input of the second amplifier, and the wireless circuitry further comprises:
   a first resistor coupled between the output of the second amplifier and the second input of the second amplifier; and
   a second resistor that couples the second input of the second amplifier to an output of the OSDAC.
11. The wireless circuitry of any of items 4-10, further comprising:
   a first adjustable current source coupled in series between the set of resistors and a power supply voltage; and
   a second adjustable current source coupled in series between the set of resistors and a ground voltage.
12. The wireless circuitry of item 11, wherein the temperature sensor is configured to adjust the first and second adjustable current sources based on the measured temperature.
13. The wireless circuitry of any of items 2-12, further comprising:
   digital logic operably coupled to the comparator and the multiplexer, wherein the comparator is configured to generate a comparator signal based on the first voltage and the threshold voltage, the digital logic being configured to adjust the multiplexer based on the comparator signal.
14. The wireless circuitry of item 13, further comprising:
   an amplifier on the radio-frequency transmission line path; and
   one or more processors, wherein the digital logic is configured to output a digital code based on the comparator signal, the digital code characterizing the power of the radio-frequency signal, and the one or more processors being configured to adjust a gain of the amplifier based on the digital code.
15. The wireless circuitry of any of items 1-14, further comprising:
   a low pass filter disposed on the first signal line and configured to reduce a common mode noise of the first voltage.
16. A power detector configured to measure a power of a signal, comprising:
   a rectifier configured to receive the signal;
   a comparator having a first input coupled to the rectifier over a first signal line and having a second output coupled to the rectifier over a second signal line, the rectifier being configured to output a first voltage on the first signal line and a second voltage on the second signal line;
   a digital-to-analog converter (DAC) on the second signal line and configured to generate an offset-compensated voltage by adding an offset voltage to the second voltage; and
   a reference generator on the second signal line between the DAC and second input of the comparator, wherein the reference generator is configured to
      generate a first threshold voltage by adding a first reference voltage to the offset-compensated voltage,
      generate a second threshold voltage by adding a second reference voltage to the offset-compensated voltage, the comparator being configured to compare the first voltage to the first and second threshold voltages, and
      adjust the second reference voltage over time.
17. The power detector of item 16, wherein the reference generator comprises:
   a first adjustable current source;
   a second adjustable current source;
   a set of resistors coupled in series between the first and second adjustable current sources;
   a first set of switches that couple the set of resistors to a third signal path, wherein the reference generator is configured to output the first threshold voltage onto the third signal path; and
   a second set of switches that couple a subset of the set of resistors to a fourth signal path, wherein
      the reference generator is configured to output the second threshold voltage onto the fourth signal path, and
      the reference generator is configured to adjust the second reference voltage over time by adjusting the first and second adjustable current sources.
18. The power detector of item 17, further comprising:
   a temperature sensor configured to measure a temperature of the power detector, the reference generator being configured to adjust the first and second adjustable current sources based on the measured temperature.
19. The power detector of any of items 17-18, further comprising:
   a multiplexer on the second signal path between the reference generator and the second input of the comparator, wherein the multiplexer has a first input coupled to the third signal path, a second input coupled to the fourth signal path, and an output coupled to the second input of the comparator; and
   digital logic configured to adjust the multiplexer based on an output of the comparator.
20. A power detector configured to measure a power of a signal, comprising:
   a rectifier configured to receive the signal;
   a first signal line coupled to a first output of the rectifier;
   a second signal line coupled to a second output of the rectifier;
   a comparator having a first input coupled to the first signal line and having a second input coupled to the second signal line;
   a reference generator on the second signal line; and
   a multiplexer on the second signal line between the reference generator and the second input of the comparator, wherein the reference generator includes
      first and second adjustable current sources,
      a set of resistors coupled in series between the first and second adjustable current sources,
      a set of switches that communicatively couple the set of resistors to the multiplexer,
      an amplifier having a first input coupled to the set of switches and having an output communicatively coupled to the multiplexer,
      a first resistor that couples the output of the amplifier to a second input of the amplifier, and
      a second resistor configured to pass an offset-compensated version of the second voltage to the second input of the amplifier.

### Clauses

1. Wireless circuitry comprising:
   a radio-frequency transmission line configured to convey a radio-frequency signal; and
   a power detector operably coupled to the radio-frequency transmission line and configured to measure a power of the radio-frequency signal, the power detector including
      a rectifier configured to convert the radio-frequency signal into a differential voltage including a first voltage on a first signal line and a second voltage on a second signal line;
      a comparator having a first input coupled to the rectifier over the first signal line and having a second input coupled to the rectifier over the second signal line, and
      a digital-to-analog converter (DAC) disposed on the second signal line, the DAC being configured to add a dynamic offset voltage to the second voltage that changes over time.
2. The wireless circuitry of clause 1, wherein the DAC comprises a resistive DAC (RDAC).
3. The wireless circuitry of clause 2, wherein the RDAC comprises:
   a resistor line coupled between a power supply voltage and a ground voltage; and
   a set of switches coupled in parallel between nodes on the resistor line and a third signal line.
4. The wireless circuitry of clause 3, further comprising one or more processors configured to:
   provide the dynamic offset voltage with a first magnitude at a first time by turning on a first set of the switches; and
   provide the dynamic offset voltage with a second magnitude at a second time by turning on a second set of the switches, the second magnitude being different than the first magnitude.
5. The wireless circuitry of any of clauses 3-4, further comprising:
   an additional RDAC operably coupled between the third signal line and the second input of the comparator.
6. The wireless circuitry of clause 5, further comprising:
   a multiplexer operably coupled between the additional RDAC and the second input of the comparator.
7. The wireless circuitry of clause 6, wherein the multiplexer has a first input terminal coupled to the additional RDAC over a fourth signal line, a second input terminal coupled to the additional RDAC over a fifth signal line, and a third input terminal coupled to the additional RDAC over a sixth signal line.
8. The wireless circuitry of clause 7, wherein the additional RDAC is configured to generate:
   a first threshold voltage on the fourth signal line by adding a first reference voltage to the second voltage and the dynamic offset voltage,
   a second threshold voltage on the fifth signal line by adding a second reference voltage to the second voltage and the dynamic offset voltage, and
   a third threshold voltage on the sixth signal line by adding a third reference voltage to the second voltage and the dynamic offset voltage.
9. The wireless circuitry of clause 8, further comprising:
   digital logic operably coupled to the comparator and the multiplexer, wherein the comparator is configured to generate a comparator signal based on the first voltage and the first, second, and third threshold voltages, the digital logic being configured to adjust the multiplexer based on the comparator signal.
10. The wireless circuitry of clause 9, further comprising:
   an amplifier on the radio-frequency transmission line path; and
   one or more processors, wherein the digital logic is configured to output a digital code based on the comparator signal, the digital code characterizing the power of the radio-frequency signal, and the one or more processors being configured to adjust a gain of the amplifier based on the digital code.
11. The wireless circuitry of any of clauses 8-10, further comprising:
   a temperature sensor configured to measure a temperature of the rectifier, the additional RDAC being configured to adjust the first, second, and third reference voltages based on the temperature of the rectifier.
12. The wireless circuitry of any of clauses 1-11, further comprising:
   a low pass filter disposed on the first signal line and configured to reduce a common mode noise of the first voltage.
13. A power detector configured to measure a power of a radio-frequency signal, comprising:
   a rectifier configured to receive the radio-frequency signal;
   a comparator having a first input coupled to the rectifier over a first signal line and having a second output coupled to the rectifier over a second signal line, the rectifier being configured to output a first voltage on the first signal line and a second voltage on the second signal line; and
   a digital-to-analog converter (DAC) on the second signal line, the DAC being configured to
      add a first offset voltage to the second voltage at a first time, and
      add a second offset voltage to the second voltage at a second time, the second offset voltage being different than the first offset voltage.
14. The power detector of clause 13, further comprising:
   a reference generator disposed on the second signal line between the DAC and the second input of the comparator.
15. The power detector of clause 14, further comprising:
   a multiplexer disposed on the second signal line between the reference generator and the second input of the comparator.
16. The power detector of clause 15, further comprising:
   digital logic coupled to an output of the comparator and configured to control the multiplexer to route different threshold voltages produced by the reference generator to the second input of the comparator.
17. The power detector of clause 16, wherein the digital logic is configured to output a digital code that identifies the measured power of the radio-frequency signal.
18. The power detector of any of clauses 14-17, wherein an output of the DAC is communicatively coupled to an input of the reference generator over a third signal line, the DAC comprising:
   a set of resistors coupled in series between a power supply voltage and a ground voltage; and
   a set of switches that couple nodes between the resistors in the set of resistors to the third signal line in parallel.
19. The power detector of any of clauses 13-18, further comprising:
   a temperature sensor configured to measure a temperature of the power detector, the DAC being configured to add the first offset voltage to the second voltage while the temperature has a first value, and the DAC being configured to add the second offset voltage to the second voltage while the temperature has a second value different than the first value.
20. A power detector configured to measure a power of a signal, comprising:
   a rectifier configured to receive the signal;
   a first signal line coupled to a first output of the rectifier;
   a second signal line coupled to a second output of the rectifier;
   a comparator having a first input coupled to the first signal line and having a second input coupled to the second signal line;
   a digital-to-analog converter (DAC) on the second signal line;
   a reference generator on the second signal line between the DAC and the second input of the comparator;
   a multiplexer on the second signal line between the reference generator and the second input of the comparator;
   digital logic operably coupled to the comparator and the multiplexer and configured to output a digital code indicative of the measured power; and
   a low pass filter on the first signal line.

## Claims

1. Wireless circuitry comprising:
a radio-frequency transmission line configured to convey a radio-frequency signal; and
a power detector operably coupled to the radio-frequency transmission line and configured to measure a power of the radio-frequency signal, the power detector including
a rectifier configured to convert the radio-frequency signal into a differential voltage including a first voltage on a first signal line and a second voltage on a second signal line;
a comparator having a first input coupled to the rectifier over the first signal line and having a second input coupled to the rectifier over the second signal line, and
a digital-to-analog converter (DAC) disposed on the second signal line, the DAC being configured to add a dynamic offset voltage to the second voltage that changes over time.

2. The wireless circuitry of claim 1, wherein the DAC comprises a resistive DAC (RDAC).

3. The wireless circuitry of claim 2, wherein the RDAC comprises:
a resistor line coupled between a power supply voltage and a ground voltage; and
a set of switches coupled in parallel between nodes on the resistor line and a third signal line.

4. The wireless circuitry of claim 3, further comprising one or more processors configured to:
provide the dynamic offset voltage with a first magnitude at a first time by turning on a first set of the switches; and
provide the dynamic offset voltage with a second magnitude at a second time by turning on a second set of the switches, the second magnitude being different than the first magnitude.

5. The wireless circuitry of any of claims 3-4, further comprising:
an additional RDAC operably coupled between the third signal line and the second input of the comparator.

6. The wireless circuitry of claim 5, further comprising:
a multiplexer operably coupled between the additional RDAC and the second input of the comparator.

7. The wireless circuitry of claim 6, wherein the multiplexer has a first input terminal coupled to the additional RDAC over a fourth signal line, a second input terminal coupled to the additional RDAC over a fifth signal line, and a third input terminal coupled to the additional RDAC over a sixth signal line.

8. The wireless circuitry of claim 7, wherein the additional RDAC is configured to generate:
a first threshold voltage on the fourth signal line by adding a first reference voltage to the second voltage and the dynamic offset voltage,
a second threshold voltage on the fifth signal line by adding a second reference voltage to the second voltage and the dynamic offset voltage, and
a third threshold voltage on the sixth signal line by adding a third reference voltage to the second voltage and the dynamic offset voltage.

9. The wireless circuitry of claim 8, further comprising:
digital logic operably coupled to the comparator and the multiplexer, wherein the comparator is configured to generate a comparator signal based on the first voltage and the first, second, and third threshold voltages, the digital logic being configured to adjust the multiplexer based on the comparator signal.

10. The wireless circuitry of claim 9, further comprising:
an amplifier on the radio-frequency transmission line path; and
one or more processors, wherein the digital logic is configured to output a digital code based on the comparator signal, the digital code characterizing the power of the radio-frequency signal, and the one or more processors being configured to adjust a gain of the amplifier based on the digital code.

11. The wireless circuitry of any of claims 8-10, further comprising:
a temperature sensor configured to measure a temperature of the rectifier, the additional RDAC being configured to adjust the first, second, and third reference voltages based on the temperature of the rectifier.

12. The wireless circuitry of any of claims 1-11, further comprising:
a low pass filter disposed on the first signal line and configured to reduce a common mode noise of the first voltage.
